# EUROPEAN PATENT APPLICATION

(11) **EP 1 431 414 A1**
(43) Date of publication of application: **23.06.2004**
(21) Application number: 02800268.1
(22) Date of filing: 27.09.2002
(51) Int. Cl.: C23C 14/34, C23C 14/08, C04B 35/453, C03C 17/245, H01B 5/14

(54) **SPUTTERING TARGET AND TRANSPARENT ELECTROCONDUCTIVE FILM**

(30) Priority: 27.09.2001 JP 2001296089; 27.09.2001 JP 2001297159
(71) Applicant: IDEMITSU KOSAN CO., LTD., Tokyo 100-8321 (JP)
(72) Inventor: INOUE, Kazuyoshi, Sodegaura-shi, Chiba 299-0293 (JP); MATSUZAKI, Shigeo, Sodegaura-shi, Chiba 299-0293 (JP)
(74) Representative: Prop, Gerrit
(86) International application number: PCT/JP2002/010051
(87) International publication number: WO 2003/029512

(57) **Abstract**

The present invention is directed to a sputtering target which inhibits formation of nodules during sputtering so as to form a transparent conductive film, thereby reliably forming the film, and to a transparent conductive film exhibiting excellent etching processability. The sputtering target is formed of a specific sintered metal oxide product composed of indium oxide, gallium oxide, and zinc oxide (1) or a specific sintered metal oxide product composed of indium oxide, gallium oxide, and germanium oxide (2).

## Description

### Technical Field

The present invention relates to a sputtering target which inhibits formation of nodules during sputtering so as to form a transparent conductive film, thereby reliably forming the film, and to a transparent conductive film exhibiting excellent etching processability.

### Technical Field

By virtue of their excellent display performance and small electric power consumption, liquid crystal display devices and electroluminescence display devices are widely employed as display units in cellular phones, personal computers, word processors, television sets, etc. In any of these apparatuses, such a display unit has a sandwich structure in which a display element is sandwiched between transparent conductive films. Among others, indium tin oxide (hereinafter abbreviated as ITO) film is usually employed as transparent conductive film used in these display units, because ITO film exhibits excellent transparency and conductivity, etching processability, and excellent adhesion to a substrate. The ITO film is generally produced through sputtering.

Although, as mentioned above, ITO film has excellent performance as transparent conductive film, the film also has a drawback. That is, when ITO film is formed through sputtering of a sputtering target, black deposits (protrusions) called nodules are formed on the surface of the target, thereby reducing the film formation speed. Also, discharge voltage is elevated, causing anomalous electric discharge, and in this case, nodules scatter to deposit on a substrate for film formation, thereby causing contamination of the formed transparent conductive film. In the case in which such nodules have been formed, film formation operation must be stopped so as to remove nodules formed on the surface of the target by polishing. Therefore, productivity of transparent conductive film is detrimentally decreased.

In order to prevent contamination of transparent conductive film caused by diffusion of nodules without stopping operation of forming transparent conductive film, there has been studied provision, in an electric power circuit of a film formation apparatus, of means for suppressing anomalous electric discharge. However, even when the means is employed, formation of nodules has not been prevented completely. For the purpose of prevention of nodule formation, a target having a theoretical relative density of about 99% has been produced through high-temperature sintering so as to attain high density and reduce pores. However, also in this case, nodule formation cannot be prevented completely. Under such circumstances, it is desired to develop a target for forming transparent conductive film, which target can suppress formation of nodules when the film is formed through sputtering and which attains reliable formation of transparent conductive film.

From another aspect, the formed ITO film is etched by use of a strong acid or aqua regia so as to form circuit patterns. The etching raises a problem that aluminum serving as a wiring material for fabricating a thin-film transistor is generally corroded. Therefore, it is also desired to develop a transparent conductive film which allows etching without adversely affecting such a wiring material.

Thus, an object of the present invention is to provide a sputtering target which suppresses formation of nodules during sputtering so as to form a transparent conductive film, thereby reliably forming the film. Another object of the invention is to provide a transparent conductive film exhibiting excellent etching processability.

### Disclosure of the Invention

The present inventors have carried out extensive studies in order to overcome the above drawbacks, and have found that nodules formed on a target for forming ITO film are basically attributed to unsputtered portions remaining on the surface of the target, and that the ease of forming such unsputtered portions depends on the crystal grain size of a metal oxide constituting the target. Briefly, the inventors have found that occurrence of nodule formation on the surface of the target markedly increases when the crystal grain size of indium oxide-a metal oxide constituting the target-exceeds a specific grain size. The present invention has been accomplished on the basis of these findings. The present invention includes a first invention and a second invention.

Accordingly, the gist of the first invention includes the following:
(1) a sputtering target formed of a sintered body of metal oxide including indium oxide, gallium oxide, and zinc oxide, wherein the metal oxide contains one or more hexagonal layered compounds selected from the group consisting of In₂O₃(ZnO)ₘ (wherein m is an integer from 2 to 10), In₂Ga₂ZnO₇, InGaZnO₄, InGaZn₂O₅, InGaZn₃O₆, InGaZn₄O₇, InGaZn₅O₈, InGaZn₆O₉, and InGaZn₇O₁₀, and the sintered body is composed of indium oxide in an amount of 90 to 99 mass% and a combination of gallium oxide and zinc oxide in a total amount of 1 to 10 mass%;
(2) a sputtering target as described in (1) above, wherein the sintered body of metal oxide is composed of indium oxide in an amount of 90 to 98 mass% and a combination of gallium oxide and zinc oxide in a total amount of 2 to 10 mass%;
(3) a sputtering target as described in (1) above, wherein the sintered body of metal oxide is composed of indium oxide in an amount of 92 to 97 mass% and a combination of gallium oxide and zinc oxide in a total amount of 3 to 8 mass%;
(4) a sputtering target as described in any of (1) to (3) above, wherein the hexagonal layered compounds have a maximum crystal grain size of 5 µm or less;
(5) a sputtering target as described in (4) above, wherein the maximum crystal grain size is 3 µm or less;
(6) a sputtering target formed of a sintered body of metal oxide including indium oxide, tin oxide, gallium oxide, and zinc oxide, wherein the metal oxide contains one or more hexagonal layered compounds selected from the group consisting of In₂O₃(ZnO)ₘ (wherein m is an integer from 2 to 10), In₂Ga₂ZnO₇, InGaZnO₄, InGaZn₂O₅, InGaZn₃O₆, InGaZn₄O₇, InGaZn₅O₈, InGaZn₆O₉, and InGaZn₇O₁₀, and the sintered body is composed of indium oxide in an amount of 70 to 94 mass%, tin oxide in an amount of 5 to 20 mass%, and a combination of gallium oxide and zinc oxide in a total amount of 1 to 10 mass%;
(7) a sputtering target as described in (6) above, wherein the sintered body of metal oxide is composed of indium oxide in an amount of 75 to 93 mass%, tin oxide in an amount of 5 to 15 mass%, and a combination of gallium oxide and zinc oxide in a total amount of 2 to 10 mass%;
(8) a sputtering target as described in (6) above, wherein the sintered body of metal oxide is composed of indium oxide in an amount of 80 to 90 mass%, tin oxide in an amount of 7 to 12 mass%, and a combination of gallium oxide and zinc oxide in a total amount of 3 to 8 mass%;
(9) a sputtering target as described in any of (6) to (8) above, wherein the hexagonal layered compounds have a maximum crystal grain size of 5 µm or less;
(10) a sputtering target as described in (9) above, wherein the maximum crystal grain size is 3 µm or less;
(11) a transparent conductive film formed of a metal oxide including indium oxide, gallium oxide, and zinc oxide, wherein the metal oxide is composed of indium oxide in an amount of 90 to 99 mass% and a combination of gallium oxide and zinc oxide in a total amount of 1 to 10 mass%;
(12) a transparent conductive film as described in (11) above, wherein the metal oxide is composed of indium oxide in an amount of 90 to 98 mass% and a combination of gallium oxide and zinc oxide in a total amount of 2 to 10 mass%;
(13) a transparent conductive film as described in (11) above, wherein the metal oxide is composed of indium oxide in an amount of 92 to 97 mass% and a combination of gallium oxide and zinc oxide in a total amount of 3 to 8 mass%;
(14) a transparent conductive film formed of a metal oxide including indium oxide, tin oxide, gallium oxide, and zinc oxide, wherein the metal oxide is composed of indium oxide in an amount of 70 to 94 mass%, tin oxide in an amount of 5 to 20 mass%, and a combination of gallium oxide and zinc oxide in a total amount of 1 to 10 mass%;
(15) a transparent conductive film as described in (14) above, wherein the metal oxide is composed of indium oxide in an amount of 75 to 93 mass%, tin oxide in an amount of 5 to 15 mass%, and a combination of gallium oxide and zinc oxide in a total amount of 2 to 10 mass%;
(16) a transparent conductive film as described in (14) above, wherein the metal oxide is composed of indium oxide in an amount of 80 to 90 mass%, tin oxide in an amount of 7 to 12 mass%, and a combination of gallium oxide and zinc oxide in a total amount of 3 to 8 mass%;
(17) a transparent conductive film which is produced by subjecting a transparent conductive film as recited in any of (14) to (16) above to heat treatment at 230°C or higher;
(18) a transparent conductive film which is produced by subjecting a transparent conductive film as recited in any of (14) to (16) above to patterning and subsequent heat treatment at 230°C or higher; and
(19) a method for producing a transparent conductive film characterized in that the method comprises sputtering a sputtering target as recited in any of (1) to (10) above for forming film.

The gist of the second invention includes the following:
(1) a sputtering target formed of a sintered body of metal oxide comprising indium oxide (a1) [A1] in an amount of 85 to 99 mass% and a combination of gallium oxide [B] and germanium oxide [C] in a total amount of 1 to 15 mass%, wherein at least the indium oxide present in the sintered body includes gallium atoms and germanium atoms, the two atomic species being dissolved therein by way of atomic replacement;
(2) a sputtering target as described in (1) above, wherein the sputtering target is formed of the sintered body of metal oxide composed of the component [A1] in an amount of 90 to 97 mass% and a combination of the component [B] and the component [C] in a total amount of 3 to 10 mass%;
(3) a sputtering target as described in (1) or (2) above, wherein indium oxide crystals including the gallium atoms or indium oxide crystals including the germanium atoms, the two atomic species being dissolved therein by way of atomic replacement, have a maximum grain size of 5 µm or less;
(4) a sputtering target as described in (3) above, wherein the maximum grain size is 3 µm or less;
(5) a sputtering target formed of a sintered body of metal oxide comprising a combination of indium oxide (a2) and tin oxide (a3) [A2] in a total amount of 90 to 99 mass% and a combination of gallium oxide [B] and germanium oxide [C] in a total amount of 1 to 10 mass%, wherein at least the indium oxide present in the sintered body includes tin atoms, gallium atoms, and germanium atoms, the three atomic species being dissolved therein by way of atomic replacement;
(6) a sputtering target as described in (5) above, wherein the sputtering target is formed of the sintered body of metal oxide composed of the component [A2] in an amount of 90 to 98 mass% and a combination of the component [B] and the component [C] in a total amount of 2 to 10 mass%;
(7) a sputtering target as described in (5) above, wherein the sputtering target is formed of the sintered body of metal oxide composed of the component [A2] in an amount of 92 to 97 mass% and a combination of the component [B] and the component [C] in a total amount of 3 to 8 mass%;
(8) a sputtering target as described in any of (5) to (7) above, wherein indium oxide crystals including tin atoms, indium oxide crystals including gallium atoms, or indium oxide crystals including germanium atoms, the three atomic species being dissolved therein by way of atomic replacement, have a maximum grain size of 5 µm or less;
(9) a sputtering target as described in (8) above, wherein the maximum grain size is 3 µm or less;
(10) a transparent conductive film formed of a metal oxide comprising indium oxide (a1) [A1] in an amount of 85 to 99 mass% and a combination of gallium oxide [B] and germanium oxide [C] in a total amount of 1 to 10 mass%, wherein at least the indium oxide present in a sintered body serving as the source of the film includes gallium atoms and germanium atoms, the two atomic species being dissolved therein by way of atomic replacement;
(11) a transparent conductive film as described in (10) above, wherein the film is formed of a metal oxide composed of the component [A1] in an amount of 90 to 97 mass% and a combination of the component [B] and the component [C] in a total amount of 3 to 10 mass%;
(12) a transparent conductive film formed of a metal oxide comprising a combination of indium oxide (a2) and tin oxide (a3) [A2] in a total amount of 90 to 99 mass% and a combination of gallium oxide [B] and germanium oxide [C] in a total amount of 1 to 10 mass%, wherein at least the indium oxide present in a sintered body serving as the source of the film includes tin atoms, gallium atoms, and germanium atoms, the three atomic species being dissolved therein by way of atomic replacement;
(13) a transparent conductive film as described in (12) above, wherein the film is formed of a metal oxide composed of the component [A2] in an amount of 90 to 98 mass% and a combination of the component [B] and the component [C] in a total amount of 2 to 10 mass%;
(14) a transparent conductive film as described in (12) above, wherein the film is formed of a metal oxide composed of the component [A2] in an amount of 92 to 97 mass% and a combination of the component [B] and the component [C] in a total amount of 3 to 8 mass%;
(15) a transparent conductive film which is produced by subjecting a transparent conductive film as recited in any of (12) to (14) above to heat treatment at 230°C or higher; and
(16) a method for producing a transparent conductive film characterized in that the method comprises sputtering a sputtering target as recited in any of (1) to (9) above for forming film.

### Best Modes for Carrying Out the Invention

Embodiments of the present invention will next be described.

### [I] First invention

The sputtering target according to the first invention (in this section, hereinafter "the first invention" may be referred to simply as "the present invention") is formed of a sintered body of metal oxide including indium oxide, gallium oxide, and zinc oxide, wherein the metal oxide contains one or more hexagonal layered compounds selected from the group consisting of In₂O₃(ZnO)ₘ (wherein m is an integer from 2 to 10), In₂Ga₂ZnO₇, InGaZnO₄, InGaZn₂O₅, InGaZn₃O₆, InGaZn₄O₇, InGaZn₅O₈, InGaZn₆O₉, and InGaZn₇O₁₀, and the sintered body is composed of indium oxide in an amount of 90 to 99 mass% and a combination of gallium oxide and zinc oxide in a total amount of 1 to 10 mass%.

Among hexagonal layered compounds which are contained in the metal oxide formed of indium oxide, gallium oxide, and zinc oxide, the metal oxide represented by formula In₂O₃(ZnO)ₘ may be any of compounds in which m is any integer from 2 to 10. However, among them, those having an m value of 2 to 7 are more preferred, from the viewpoint of low volume resistivity.

The metal oxide formed of indium oxide, gallium oxide, and zinc oxide is composed of indium oxide in an amount of 90 to 99 mass% and a combination of gallium oxide and zinc oxide in a total amount of 1 to 10 mass%. The reasons why the metal oxide has the foregoing composition are as follows. When the total amount of gallium oxide and zinc oxide is less than 1 mass%, etching processability of the transparent conductive film obtained by sputtering the sputtering target is reduced, whereas when the total amount of gallium oxide and zinc oxide is in excess of 10 mass%, conductivity of the obtained transparent conductive film decreases. Regarding the composition of the metal oxide, the amount of indium oxide and the total amount of gallium oxide and zinc oxide are preferably 90 to 98 mass% and 2 to 10 mass%, respectively, more preferably 92 to 97 mass% and 3 to 8 mass%, respectively.

Preferably, the amount of gallium oxide contained in the metal oxide is equal to or greater than that of zinc oxide contained in the metal oxide, since the transparent conductive film obtained by sputtering the sputtering target has excellent transparency. The gallium oxide content is more preferably at least 1.5 times the zinc oxide content, further more preferably at least twice the zinc oxide content.

The hexagonal layered compounds contained in the metal oxide preferably have a maximum crystal grain size of 5 µm or less. This is because, in the sintered body of the metal oxide, when the maximum crystal grain size of the hexagonal layered compounds present in the grain boundary of indium oxide crystals is controlled to 5 µm or less, growth of indium oxide crystals in contact with the hexagonal layered compounds can be suppressed, and the maximum grain size of indium oxide crystals can be controlled to 10 µm or less. Thus, more preferably, the maximum crystal grain size of the hexagonal layered compounds is controlled to 3 µm or less, whereby the maximum grain size of indium oxide crystals present in the sintered body can be controlled to 7 µm or less. Thus, when the grain size of the crystals present in the sintered body of metal oxide is reduced, nodule formation can be prevented during film formation by sputtering the sputtering target formed of the sintered body. From another aspect, the effect of reducing the grain size of indium oxide crystals can be enhanced as the hexagonal layered compound content is elevated. However, since conductivity of the transparent conductive film obtained by sputtering the sputtering target decreases in this case, the hexagonal layered compounds are formed in amounts corresponding to a total amount of gallium oxide and zinc oxide of 10 mass% or less.

Meanwhile, hexagonal layered compounds present in the metal oxide can be identified through analysis; for example, X-ray diffraction analysis or EPMA (Electron Probe Micro-Analysis). The maximum grain size of hexagonal layered compound crystals is determined through the following procedure. After the surface of the sputtering target has been polished, the surface is observed at five points under a scanning electron microscope at a magnification of ×2,500. In the case where the sputtering target has a circular cross-section, the five points include the center of the circle (one point) and midpoints (four points) between the periphery and the center, the midpoints located on two lines which intersect each other at right angle at the center. In the case where the sputtering target has a square cross-section, the five points include the center of the square (one point) and respective midpoints (four points) between the vertices and the center, the midpoints located on the two diagonals which intersect each other at the center. The longest diameter of the largest grain observed at each point (frame of 50 µm × 50 µm) is measured, and the longest diameter values measured in the five frames are averaged.

Alternatively, the sputtering target according to the present invention may be formed of a sintered body of 4-component metal oxide including indium oxide, tin oxide, gallium oxide, and zinc oxide, wherein the metal oxide contains one or more hexagonal layered compounds selected from the group consisting of In₂O₃(ZnO)ₘ (wherein m is an integer from 2 to 10), In₂Ga₂ZnO₇, InGaZnO₄, InGaZn₂O₅, InGaZn₃O₆, InGaZn₄O₇, InGaZn₅O₈, InGaZn₆O₉, and InGaZn₇O₁₀, and the sintered body is composed of indium oxide in an amount of 70 to 94 mass%, tin oxide in an amount of 5 to 20 mass%, and a combination of gallium oxide and zinc oxide in a total amount of 1 to 10 mass%.

The amount of the tin oxide component present in the sputtering target formed of a sintered body of a 4-component metal oxide is controlled to 5 to 20 mass%. The reasons why the target has the foregoing composition are as follows. When the tin oxide content is less than 5 mass%, electric resistance of the sputtering target may fail to sufficiently decrease, whereas when the tin oxide content is in excess of 20 mass%, the electric resistance may excessively increase. Thus, the tin oxide content of the sintered body is more preferably 5 to 15 mass%, further more preferably 7 to 12 mass%. Furthermore, the total amount of the gallium oxide component and the zinc oxide component contained in the sputtering target is controlled to 1 to 10 mass%. The criteria of the amount are as follows. When the total amount of gallium oxide and zinc oxide is less than 1 mass%, the produced transparent conductive film has a crystalline nature, thereby reducing etching processability, whereas when the total amount of gallium oxide and zinc oxide is in excess of 10 mass%, conductivity of the obtained transparent conductive film decreases.

The metal oxide constituting the sputtering target formed of the sintered body of a 4-component metal oxide is preferably composed of indium oxide in an amount of 75 to 93 mass%, tin oxide in an amount of 5 to 15 mass%, and a combination of gallium oxide and zinc oxide in a total amount of 2 to 10 mass%. More preferably, the metal oxide is composed of indium oxide in an amount of 80 to 90 mass%, tin oxide in an amount of 7 to 12 mass%, and a combination of gallium oxide and zinc oxide in a total amount of 3 to 8 mass%.

Preferably, the amount of tin oxide contained in the sputtering target is greater than that of zinc oxide contained in the sputtering target, since conductivity of the transparent conductive film obtained by sputtering the sputtering target can be enhanced. The tin oxide content is preferably at least 1.5 times the zinc oxide content, more preferably at least twice the zinc oxide content.

The hexagonal layered compounds contained in the sputtering target preferably have a maximum crystal grain size of 5 µm or less. This is because, in the sintered body of the metal oxide, by controlling the maximum crystal grain size of the hexagonal layered compounds present in the grain boundary of indium oxide crystals to 5 µm or less, growth of indium oxide crystals in contact with the hexagonal layered compounds can be suppressed, and the maximum grain size of indium oxide crystals can be suppressed to 10 µm or less. More preferably, the maximum crystal grain size of the hexagonal layered compounds is controlled to 3 µm or less, whereby the maximum grain size of indium oxide crystals present in the sintered body can be suppressed to 7 µm or less. Thus, when the grain size of indium oxide crystals present in the sintered body constituting the sputtering target is reduced, nodule formation can be prevented during film formation.

Next, the sputtering target can be produced through, for example, the following procedure. Powders of indium oxide, gallium oxide, zinc oxide, and optional tin oxide are mixed and pulverized, to thereby produce fine powder. The fine powder is granulated through casting or spray drying, and the formed granules are press-molded and sintered. The sintered body is cut, to thereby produce the sputtering target. Mixing and pulverization of metal oxides serving as raw materials can be performed by means of a wet-type mixing-pulverizer; e.g., a wet ball mill or a beads mill, or through ultrasonication. Raw material powders are preferably pulverized so that the pulverized product has a mean particle size of 1 µm or less.

The above metal oxide is fired in air or an oxygen-containing atmosphere at 1,300 to 1,700°C, preferably 1,450 to 1,600°C for 2 to 36 hours, preferably 4 to 24 hours. The temperature elevation rate during firing preferably falls within a range of 2 to 10 °C/min. The thus-obtained sintered body is cut, to thereby form sputtering target having a suitable shape adaptable to a sputtering apparatus. The target is attached to a jig for placing the target in the sputtering apparatus.

The transparent conductive film according to the present invention is formed on a substrate by sputtering the aforementioned sputtering target. A substrate of high transparency is preferably employed as the substrate, and conventionally used glass substrates and transparent synthetic resin film and sheets can be employed. Examples of the synthetic resin to be employed include polycarbonate resin, poly(methyl methacrylate) resin, polyester resin, polyether sulfone resin, and polyarylate resins.

A variety of sputtering apparatuses can be employed for forming the transparent conductive film through sputtering. Particularly, a magnetron sputtering apparatus is preferably used. When such a magnetron sputtering apparatus is used, plasma power-one of the sputtering conditions for forming a film-varies depending on the surface area of the target employed and the thickness of the transparent conductive film to be produced. However, a transparent conductive film having a desired film thickness can be produced generally under the following sputtering conditions: plasma power; 0.3 to 4 W/cm² (i.e., 1 cm² of the surface area of the target), and film formation time; 5 to 120 minutes. The thickness of the transparent conductive film, which varies depending on the display apparatus to which the film is applied, is generally 200 to 6,000 Å, preferably 300 to 2,000 Å.

The thus-produced transparent conductive film of the present invention is formed of a metal oxide including indium oxide, gallium oxide, and zinc oxide, wherein the metal oxide is composed of indium oxide in an amount of 90 to 99 mass% and a combination of gallium oxide and zinc oxide in a total amount of 1 to 10 mass%.

Since the transparent conductive film is formed of a metal oxide composed of indium oxide in an amount of 90 to 99 mass% and a combination of gallium oxide and zinc oxide in a total amount of 1 to 10 mass%, the film exhibits excellent transparency and conductivity and has excellent etching characteristics by virtue of its amorphous nature. When the total amount of gallium oxide and zinc oxide is less than 1 mass%, the transparent conductive film has a crystalline nature, thereby reducing etching processability, whereas when the total amount of gallium oxide and zinc oxide is in excess of 10 mass%, conductivity of the transparent conductive film decreases. In addition, the transparent conductive film preferably has a composition in which the amount of indium oxide and the total amount of gallium oxide and zinc oxide are 90 to 98 mass% and 2 to 10 mass%, respectively, from the viewpoint of more excellent conductivity and etching characteristics. More preferably, the film has a composition in which the amount of indium oxide and the total amount of gallium oxide and zinc oxide are 92 to 97 mass% and 3 to 8 mass%, respectively.

The transparent conductive film of the present invention is formed of a 4-component metal oxide including indium oxide, tin oxide, gallium oxide, and zinc oxide, wherein the metal oxide is composed of indium oxide in an amount of 70 to 94 mass%, tin oxide in an amount of 5 to 20 mass%, and a combination of gallium oxide and zinc oxide in a total amount of 1 to 10 mass%.

Since the transparent conductive film is formed of the 4-component metal oxide including indium oxide, tin oxide, gallium oxide, and zinc oxide, wherein the metal oxide is composed of indium oxide in an amount of 70 to 94 mass%, tin oxide in an amount of 5 to 20 mass%, and a combination of gallium oxide and zinc oxide in a total amount of 1 to 10 mass%, the film exhibits excellent transparency and conductivity and has excellent etching characteristics by virtue of its amorphous nature. Herein, the amount of the tin oxide component present in the transparent conductive film is controlled to 5 to 20 mass%. This is because, when the tin oxide content is less than 5 mass%, electric resistance of the film may fail to decrease, whereas when the tin oxide content is in excess of 20 mass%, the electric resistance of the transparent conductive film may increase. Thus, the tin oxide content of the sintered body is more preferably 5 to 15 mass%, further more preferably 7 to 12 mass%.

Preferably, the amount of tin oxide contained in the transparent conductive film formed of a 4-component metal oxide is greater than that of zinc oxide from the viewpoint of excellent conductivity. The tin oxide content of the transparent conductive film is more preferably at least 1.5 times the zinc oxide content, further more preferably at least twice the zinc oxide content.

The total amount of gallium oxide and zinc oxide contained in the transparent conductive film formed of the metal oxide is controlled to 1 to 10 mass%. The criteria of the amount are as follows. When the total amount of gallium oxide and zinc oxide is less than 1 mass%, the transparent conductive film has a crystalline nature, thereby reducing etching processability, whereas when the total amount is in excess of 10 mass%, conductivity of the transparent conductive film decreases. The total amount of gallium oxide and zinc oxide contained in the transparent conductive film is preferably 2 to 10 mass%, more preferably 3 to 8 mass%.

When the amorphous transparent conductive film formed of the 4-component metal oxide is subjected to heat treatment at 230°C or higher after film formation, the transparent conductive film becomes crystalline, thereby producing a transparent conductive film having higher conductivity. The heat treatment is preferably performed at 250°C or higher, more preferably 260°C or higher. In this case, the heat treatment is performed for 0.1 to five hours. The heat treatment is performed preferably after completion of patterning of the amorphous transparent conductive film obtained by sputtering the sputtering target. The patterning can be performed through a conventional method such as photolithography.

The thus-produced transparent conductive film is endowed with excellent light transmittance; i.e., about 75% for a beam of 400 nm and about 90% for a beam of 550 nm; high conductivity; and a work function of 4.6 eV or lower. Thus, when the film is used in an organic electroluminescence element, contact resistance with an electron injection layer can be lowered. Accordingly, the transparent conductive film of the present invention is suitably employed as a transparent electrode used in a variety of display devices such as liquid crystal display devices and organic electroluminescence display elements, which are required to have high transparency and conductivity.

The present invention will next be described in more detail by way of Examples and Comparative Examples.

### [Example I-1]

### (1) Production of sputtering target

Indium oxide powder, gallium oxide powder, and zinc oxide powder, serving as raw materials, were mixed such that the compositional proportions of the components were adjusted to 93 mass%, 4 mass%, and 3 mass%, respectively. The thus-prepared metal oxide powder mixture was fed to a wet ball mill and pulverized through mixing for 10 hours, to thereby form a raw material powder having a mean particle size of 1.8 to 2 µm. The thus-formed raw material powder was dried and granulated by means of a spray drier. The resultant granules were charged into a metal mold and press-molded by means of a presser, to thereby obtain a molded disk (diameter: 10 cm, thickness: 5 mm).

The obtained molded disk was placed in a sintering furnace and sintered in a pressurized oxygen gas atmosphere for six hours, while the sintering temperature was maintained within a range of 1,420 to 1,480°C.

Analysis X-ray diffractometry and EPMA of the above sintered body revealed that hexagonal layered compounds represented by In₂O₃(ZnO)₄ or InGaZnO₄ had been formed in the sintered body. The maximum crystal grain size of the sintered body was determined to be 2.8 µm through the following procedure. Briefly, the sintered disk product was photographed at five points under a scanning electron microscope at a magnification of ×2,500, wherein the five points included the center of the circle (one point) and midpoints (four points) between the periphery and the center, the midpoints located on two lines which intersect each other at right angle at the center. The longest diameter of the largest grain observed at each point (frame of 50 µm × 50 µm) was measured, and the longest diameter values measured in the five frames were averaged. The sintered body was found to have a density of 6.6 g/cm³, which is 94% the corresponding theoretical density. The bulk resistivity of the sintered body, as determined through the four-probe method, was found to be 2.4 × 10⁻³ Ω·cm.

The thus-produced sintered body was cut, to thereby produce a sputtering target having a diameter of about 10 cm and a thickness of about 5 mm.

### (2) Observation of nodule formation

The sputtering target which had been produced in (1) above was bonded to a copper plate and set in a DC magnetron sputtering apparatus. Sputtering was performed continuously for 30 hours in an atmosphere of a mixture gas of argon containing 3% hydrogen. Other sputtering conditions employed were as follows: pressure; 3 × 10⁻¹ Pa, base pressure; 5 × 10 ⁴ Pa, substrate temperature; 25°C, and input power; 100 W. Notably, the hydrogen was added to the atmosphere so as to promote formation of nodules.

The surface conditions of the target after sputtering were observed under a stereoscopic microscope at a magnification of ×50, and the following procedure was employed: counting the number of nodules having a size of 20 µm or greater formed in each field of vision (3 mm²) and averaging the values. Through this procedure, no nodule was identified on the surface of the sputtering target used herein.

The composition, physical properties, and observation regarding nodule formation of the sputtering target produced in Example I-1 are shown in Table I-1.

In the Table, "Example I-1" is abbreviated as "Example 1" for the sake of convenience. The same convention is applied to other Examples and Comparative Examples and to Tables I-1 to I-6.

### (3) Production of transparent conductive film

The sputtering target which had been produced in (1) above was set in a DC magnetron sputtering apparatus. Transparent conductive film was formed on a glass substrate by sputtering the target at room temperature. The sputtering conditions employed were as follows: atmosphere; mixture gas of argon containing a small amount of oxygen, sputtering pressure; 3 × 10⁻¹ Pa, base pressure; 5 × 10⁻⁴ Pa, substrate temperature; 25°C, input power; 100 W, and sputtering time; 20 minutes.

As a result, a transparent conductive film having a thickness of about 2,000 Å was formed on the glass substrate, whereby a transparent glass plate was produced.

### (4) Evaluation of transparent conductive film

The transparent conductive film serving as a surface layer of the transparent conductive glass plate obtained in (3) above was evaluated in terms of the following properties. The results are shown in Table I-2.

### (1) Conductivity

As an index for conductivity, specific resistance of the transparent conductive film was measured through the four-probe method and found to be 290 × 10⁻⁶ Ω·cm.

### (2) Transparency

As an index for transparency, light transmittance of the film was measured by means of a spectrophotometer and found to be 75% for a beam of 400 nm and 91% for a beam of 550 nm.

### (3) Crystallinity

Crystallinity of the film was determined through X-ray diffractometry, revealing that the transparent conductive film was amorphous.

### (4) Etching characteristics

In order to investigate etching characteristics of the film, etching was performed at 30°C by use of a 3.5 mass% aqueous oxalic acid solution as an etchant. The etched surface conditions of the transparent conductive film after etching were observed under a spectroscopic microscope. No etching residue was observed on the etched surface of the transparent conductive film.

The above procedure was repeated, except that a mixed acid (nitric acid : phosphoric acid : acetic acid : water = 2 : 17 : 1,800 : 1,000) was employed as an etchant, to thereby evaluate etching characteristics. No etching residue was observed on the etched surface of the transparent conductive film.

### (5) Work function

Work function of the transparent conductive film was measured through atmospheric ultraviolet photoelectron spectroscopy and was found to be 4.38 eV.

### [Example I-2]

### (1) Production of sputtering target and observation of nodule formation

The procedure of Example I-1 (1) was repeated, except that indium oxide, gallium oxide, and zinc oxide were used as raw materials in amounts of 91 parts by mass, 6 parts by mass, and 3 parts by mass, respectively, to thereby produce a sputtering target. In the produced sputtering target, formation of a hexagonal layered compound represented by In₂Ga₂ZnO₇ was confirmed.

In a manner similar to that employed in Example I-1 (2), the sputtering target was observed so as to identify nodule formation during sputtering.

The composition, physical properties, and observation regarding nodule formation of the sputtering target are shown in Table I-1.

### (2) Production and evaluation of transparent conductive film

The procedure of Example I-1 (3) was repeated, except that the sputtering target which had been produced in (1) above was sputtered, to thereby produce a transparent conductive film.

In a manner similar to that employed in Example I-1 (4), the transparent conductive film was evaluated. The results are shown in Table I-2.

### [Example I-3]

### (1) Production of sputtering target and observation of nodule formation

The procedure of Example I-1 (1) was repeated, except that indium oxide, gallium oxide, and zinc oxide were used as raw materials in amounts of 94 parts by mass, 4 parts by mass, and 2 parts by mass, respectively, to thereby produce a sputtering target. In the produced sputtering target, formation of a hexagonal layered compound represented by InGaZnO₄ was confirmed.

In a manner similar to that employed in Example I-1 (2), the sputtering target was observed so as to identify nodule formation during sputtering.

The composition, physical properties, and observation regarding nodule formation of the sputtering target are shown in Table I-1.

### (2) Production and evaluation of transparent conductive film

The procedure of Example I-1 (3) was repeated, except that the sputtering target which had been produced in (1) above was sputtered, to thereby produce a transparent conductive film.

In a manner similar to that employed in Example I-1 (4), the transparent conductive film was evaluated. The results are shown in Table I-2.

### [Example I-4]

### (1) Production of sputtering target and observation of nodule formation

The procedure of Example I-1 (1) was repeated, except that indium oxide, gallium oxide, and zinc oxide were used as raw materials in amounts of 92 parts by mass, 6 parts by mass, and 2 parts by mass, respectively, to thereby produce a sputtering target. In the produced sputtering target, formation of a hexagonal layered compound represented by In₂Ga₂ZnO₇ was confirmed.

In a manner similar to that employed in Example I-1 (2), the sputtering target was observed so as to identify nodule formation during sputtering.

The composition, physical properties, and observation regarding nodule formation of the sputtering target are shown in Table I-1.

### (2) Production and evaluation of transparent conductive film

The procedure of Example I-1 (3) was repeated, except that the sputtering target which had been produced in (1) above was sputtered, to thereby produce a transparent conductive film.

In a manner similar to that employed in Example I-1 (4), the transparent conductive film was evaluated. The results are shown in Table I-2.

### [Comparative Example I-1]

### (1) Production of sputtering target and observation of nodule formation

The procedure of Example I-1 (1) was repeated, except that indium oxide (90 parts by mass) and gallium oxide (10 parts by mass) were used as raw materials, to thereby produce a sputtering target. In the produced sputtering target, formation of a hexagonal layered compound was not confirmed.

In a manner similar to that employed in Example I-1 (2), the sputtering target was observed so as to identify nodule formation during sputtering. Through observation at a magnification of ×50, 21 nodules were identified in a field of vision (3 mm²) on the surface of the sputtering target after completion of sputtering for continuous 30 hours.

The composition, physical properties, and observation regarding nodule formation of the sputtering target are shown in Table I-1.

### (2) Production and evaluation of transparent conductive film

The procedure of Example I-1 (3) was repeated, except that the sputtering target which had been produced in (1) above was sputtered, to thereby produce a transparent conductive film.

In a manner similar to that employed in Example I-1 (4), the transparent conductive film was evaluated. The results are shown in Table I-2.

### [Comparative Example I-2]

### (1) Production of sputtering target and observation of nodule formation

The procedure of Example I-1 (1) was repeated, except that indium oxide and zinc oxide were used as raw materials in amounts of 90 parts by mass and 10 parts by mass, respectively, to thereby produce a sputtering target. In the produced sputtering target, formation of a hexagonal layered compound represented by In₂O₃(ZnO)₇ was confirmed.

In a manner similar to that employed in Example I-1 (2), the sputtering target was observed so as to identify nodule formation during sputtering. Through observation at a magnification of ×50, no nodule was identified in a field of vision (3 mm²) on the surface of the sputtering target after completion of sputtering for continuous 30 hours.

The composition, physical properties, and observation regarding nodule formation of the sputtering target are shown in Table I-1.

### (2) Production and evaluation of transparent conductive film

The procedure of Example I-1 (3) was repeated, except that the sputtering target which had been produced in (1) above was sputtered, to thereby produce a transparent conductive film.

In a manner similar to that employed in Example I-1 (4), the transparent conductive film was evaluated. The results are shown in Table I-2.

### [Comparative Example I-3]

### (1) Production of sputtering target and observation of nodule formation

The procedure of Example I-1 (1) was repeated, except that indium oxide and gallium oxide were used as raw materials in amounts of 95 parts by mass and 5 parts by mass, respectively, to thereby produce a sputtering target. In the produced sputtering target, formation of a hexagonal layered compound was not confirmed.

In a manner similar to that employed in Example I-1 (2), the sputtering target was observed so as to identify nodule formation during sputtering. Through observation at a magnification of ×50, 32 nodules were identified in a field of vision (3 mm²) on the surface of the sputtering target after completion of sputtering for continuous 30 hours.

The composition, physical properties, and observation regarding nodule formation of the sputtering target are shown in Table I-1.

### (2) Production and evaluation of transparent conductive film

The procedure of Example I-1 (3) was repeated, except that the sputtering target which had been produced in (1) above was sputtered, to thereby produce a transparent conductive film.

In a manner similar to that employed in Example I-1 (4), the transparent conductive film was evaluated. The results are shown in Table I-2.

### [Comparative Example I-4]

### (1) Production of sputtering target and observation of nodule formation

The procedure of Example I-1 (1) was repeated, except that indium oxide and zinc oxide were used as raw materials in amounts of 97 parts by mass and 3 parts by mass, respectively, to thereby produce a sputtering target. In the produced sputtering target, formation of a hexagonal layered compound represented by In₂O₃(ZnO)₄ was confirmed.

In a manner similar to that employed in Example I-1 (2), the sputtering target was observed so as to identify nodule formation during sputtering. Through observation at a magnification of ×50, 12 nodules were identified in a field of vision (3 mm²) on the surface of the sputtering target after completion of sputtering for continuous 30 hours.

The composition, physical properties, and observation regarding nodule formation of the sputtering target are shown in Table I-1.

### (2) Production and evaluation of transparent conductive film

The procedure of Example I-1 (3) was repeated, except that the sputtering target which had been produced in (1) above was sputtered, to thereby produce a transparent conductive film.

In a manner similar to that employed in Example I-1 (4), the transparent conductive film was evaluated. The results are shown in Table I-2.

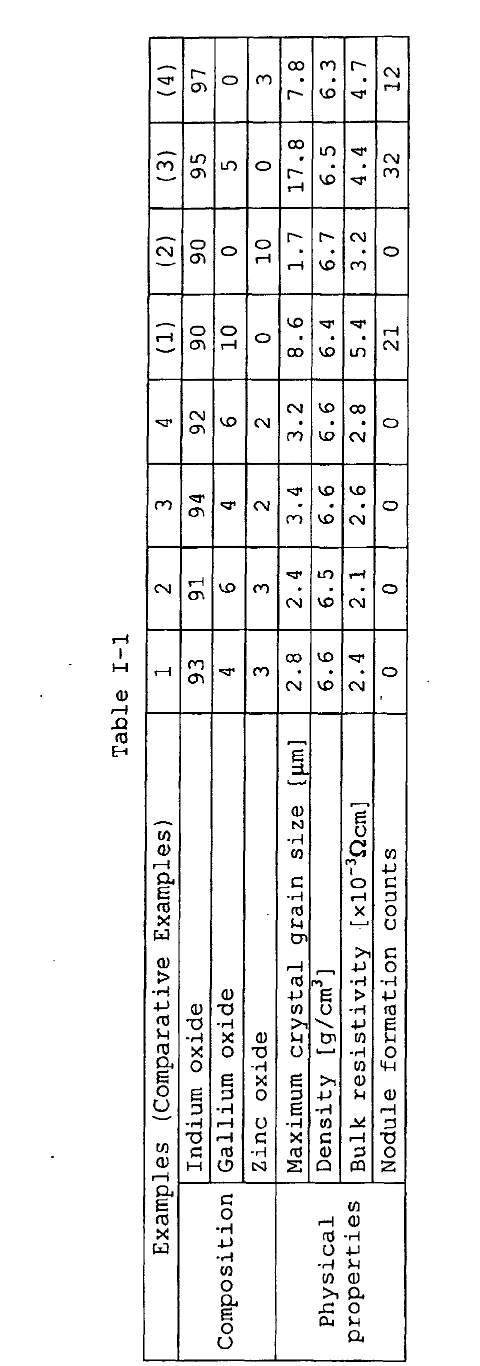

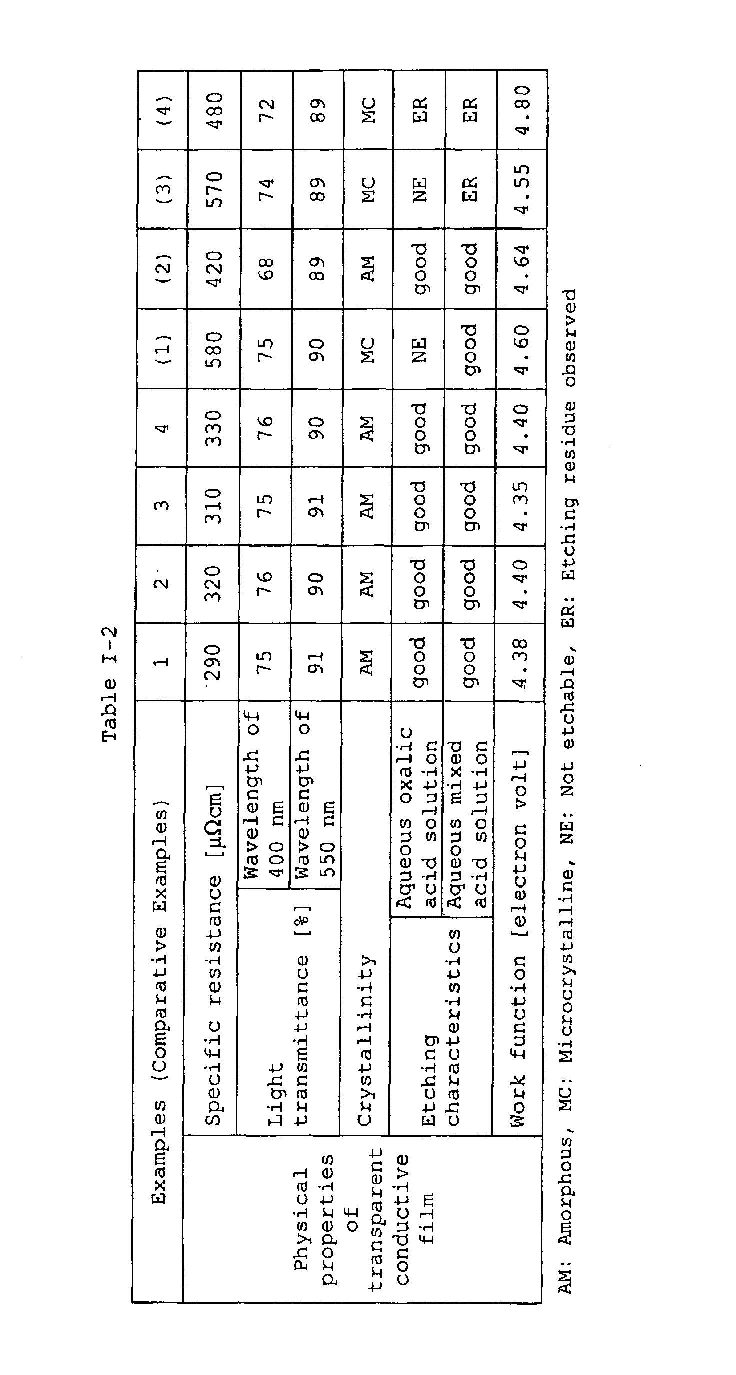

### [Example I-5]

### (1) Production of sputtering target and observation of nodule formation

The procedure of Example I-1 (1) was repeated, except that indium oxide, tin oxide, gallium oxide, and zinc oxide were used as raw materials in amounts of 86 parts by mass, 6 parts by mass, 6 parts by mass, and 2 parts by mass, respectively, to thereby produce a sputtering target. In the produced sputtering target, formation of a hexagonal layered compound represented by In₂Ga₂ZnO₇ was confirmed.

In a manner similar to that employed in Example I-1 (2), the sputtering target was observed so as to identify nodule formation during sputtering.

The composition, physical properties, and observation regarding nodule formation of the sputtering target are shown in Table I-3.

### (2) Production and evaluation of transparent conductive film

The procedure of Example I-1 (3) was repeated, except that the sputtering target which had been produced in (1) above was sputtered, to thereby produce a transparent conductive film.

In a manner similar to that employed in Example I-1 (4), the transparent conductive film was evaluated. The results are shown in Table I-4.

### [Example I-6]

### (1) Production of sputtering target and observation of nodule formation

The procedure of Example I-1 (1) was repeated, except that indium oxide, tin oxide, gallium oxide, and zinc oxide were used as raw materials in amounts of 86 parts by mass, 6 parts by mass, 4 parts by mass, and 2 parts by mass, respectively, to thereby produce a sputtering target. In the produced sputtering target, formation of a hexagonal layered compound represented by In₂Ga₂ZnO₇ was confirmed.

In a manner similar to that employed in Example I-1 (2), the sputtering target was observed so as to identify nodule formation during sputtering.

The composition, physical properties, and observation regarding nodule formation of the sputtering target are shown in Table I-3.

### (2) Production and evaluation of transparent conductive film

The procedure of Example I-1 (3) was repeated, except that the sputtering target which had been produced in (1) above was sputtered, to thereby produce a transparent conductive film.

In a manner similar to that employed in Example I-1 (4), the transparent conductive film was evaluated. The results are shown in Table I-4.

### [Example I-7]

### (1) Production of sputtering target and observation of nodule formation

The procedure of Example I-1 (1) was repeated, except that indium oxide, tin oxide, gallium oxide, and zinc oxide were used as raw materials in amounts of 84 parts by mass, 8 parts by mass, 5 parts by mass, and 3 parts by mass, respectively, to thereby produce a sputtering target. In the produced sputtering target, formation of a hexagonal layered compound represented by InGaZnO₄ was confirmed.

In a manner similar to that employed in Example I-1 (2), the sputtering target was observed so as to identify nodule formation during sputtering.

The composition, physical properties, and observation regarding nodule formation of the sputtering target are shown in Table I-3.

### (2) Production and evaluation of transparent conductive film

The procedure of Example I-1 (3) was repeated, except that the sputtering target which had been produced in (1) above was sputtered, to thereby produce a transparent conductive film.

In a manner similar to that employed in Example I-1 (4), the transparent conductive film was evaluated. The results are shown in Table I-4.

### [Example I-8]

### (1) Production of sputtering target and observation of nodule formation

The procedure of Example I-1 (1) was repeated, except that indium oxide, tin oxide, gallium oxide, and zinc oxide were used as raw materials in amounts of 85 parts by mass, 8 parts by mass, 4 parts by mass, and 3 parts by mass, respectively, to thereby produce a sputtering target. In the produced sputtering target, formation of a hexagonal layered compound represented by InGaZnO₄ was confirmed.

In a manner similar to that employed in Example I-1 (2), the sputtering target was observed so as to identify nodule formation during sputtering.

The composition, physical properties, and observation regarding nodule formation of the sputtering target are shown in Table I-3.

### (2) Production and evaluation of transparent conductive film

The procedure of Example I-1 (3) was repeated, except that the sputtering target which had been produced in (1) above was sputtered, to thereby produce a transparent conductive film.

In a manner similar to that employed in Example I-1 (4), the transparent conductive film was evaluated. The results are shown in Table I-4.

### [Example I-9]

### (1) Production of sputtering target and observation of nodule formation

The procedure of Example I-1 (1) was repeated, except that indium oxide, tin oxide, gallium oxide, and zinc oxide were used as raw materials in amounts of 85 parts by mass, 8 parts by mass, 3 parts by mass, and 4 parts by mass, respectively, to thereby produce a sputtering target. In the produced sputtering target, formation of a hexagonal layered compound represented by InGaZn₂O₅ was confirmed.

In a manner similar to that employed in Example I-1 (2), the sputtering target was observed so as to identify nodule formation during sputtering.

The composition, physical properties, and observation regarding nodule formation of the sputtering target are shown in Table I-3.

### (2) Production and evaluation of transparent conductive film

The procedure of Example I-1 (3) was repeated, except that the sputtering target which had been produced in (1) above was sputtered, to thereby produce a transparent conductive film.

In a manner similar to that employed in Example I-1 (4), the transparent conductive film was evaluated. The results are shown in Table I-4.

### [Example I-10]

### (1) Production of sputtering target and observation of nodule formation

The procedure of Example I-1 (1) was repeated, except that indium oxide, tin oxide, gallium oxide, and zinc oxide were used as raw materials in amounts of 86 parts by mass, 8 parts by mass, 2 parts by mass, and 4 parts by mass, respectively, to thereby produce a sputtering target. In the produced sputtering target, formation of a hexagonal layered compound represented by In₂O₃(ZnO)₄ and a hexagonal layered compound represented by InGaZnO₄ were confirmed.

In a manner similar to that employed in Example I-1 (2), the sputtering target was observed so as to identify nodule formation during sputtering.

The composition, physical properties, and observation regarding nodule formation of the sputtering target are shown in Table I-3.

### (2) Production and evaluation of transparent conductive film

The procedure of Example I-1 (3) was repeated, except that the sputtering target which had been produced in (1) above was sputtered, to thereby produce a transparent conductive film.

In a manner similar to that employed in Example I-1 (4), the transparent conductive film was evaluated. The results are shown in Table I-4.

### [Comparative Example I-5]

### (1) Production of sputtering target and observation of nodule formation

The procedure of Example I-1 (1) was repeated, except that indium oxide and tin oxide were used as raw materials in amounts of 90 parts by mass and 10 parts by mass, respectively, to thereby produce a sputtering target. In the produced sputtering target, formation of a hexagonal layered compound was not confirmed.

In a manner similar to that employed in Example I-1 (2), the sputtering target was observed so as to identify nodule formation during sputtering. Through observation at a magnification of ×50, 43 nodules were identified in a field of vision (3 mm²) on the surface of the sputtering target after completion of sputtering for continuous 30 hours.

The composition, physical properties, and observation regarding nodule formation of the sputtering target are shown in Table I-5.

### (2) Production and evaluation of transparent conductive film

The procedure of Example I-1 (3) was repeated, except that the sputtering target which had been produced in (1) above was sputtered, to thereby produce a transparent conductive film.

In a manner similar to that employed in Example I-1 (4), the transparent conductive film was evaluated. The results are shown in Table I-6.

### [Comparative Example I-6]

### (1) Production of sputtering target and observation of nodule formation

The procedure of Example I-1 (1) was repeated, except that indium oxide, tin oxide, and zinc oxide were used as raw materials in amounts of 88 parts by mass, 9 parts by mass, and 3 parts by mass, respectively, to thereby produce a sputtering target. In the produced sputtering target, formation of a hexagonal layered compound was not confirmed.

In a manner similar to that employed in Example I-1 (2), the sputtering target was observed so as to identify nodule formation during sputtering.

The composition, physical properties, and observation regarding nodule formation of the sputtering target are shown in Table I-5.

### (2) Production and evaluation of transparent conductive film

The procedure of Example I-1 (3) was repeated, except that the sputtering target which had been produced in (1) above was sputtered, to thereby produce a transparent conductive film.

In a manner similar to that employed in Example I-1 (4), the transparent conductive film was evaluated. The results are shown in Table I-6.

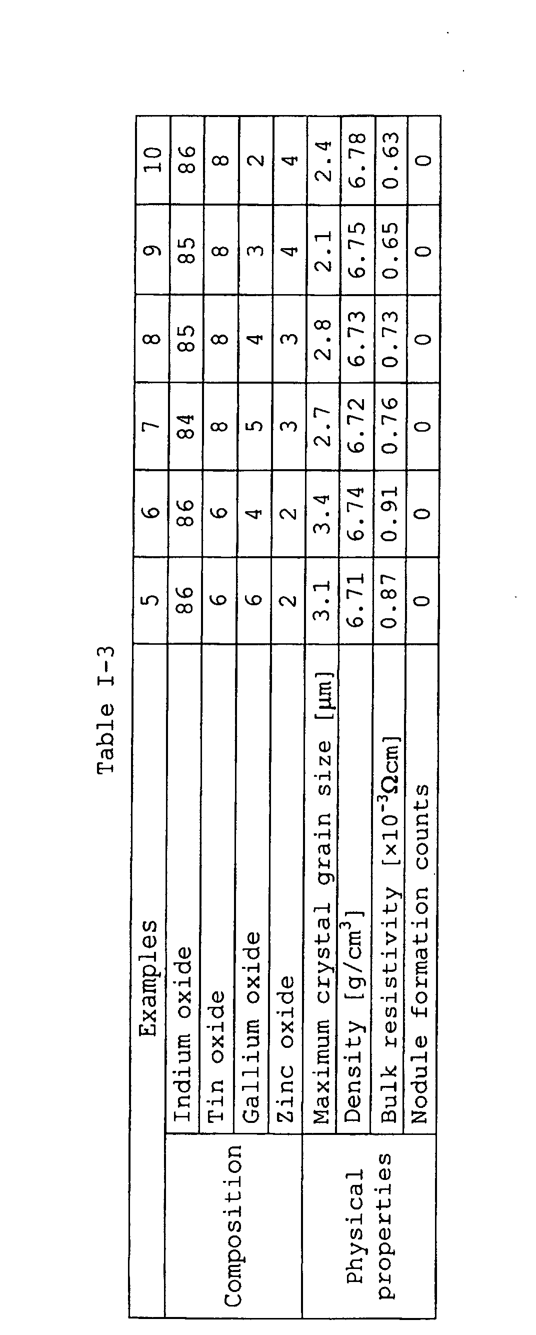

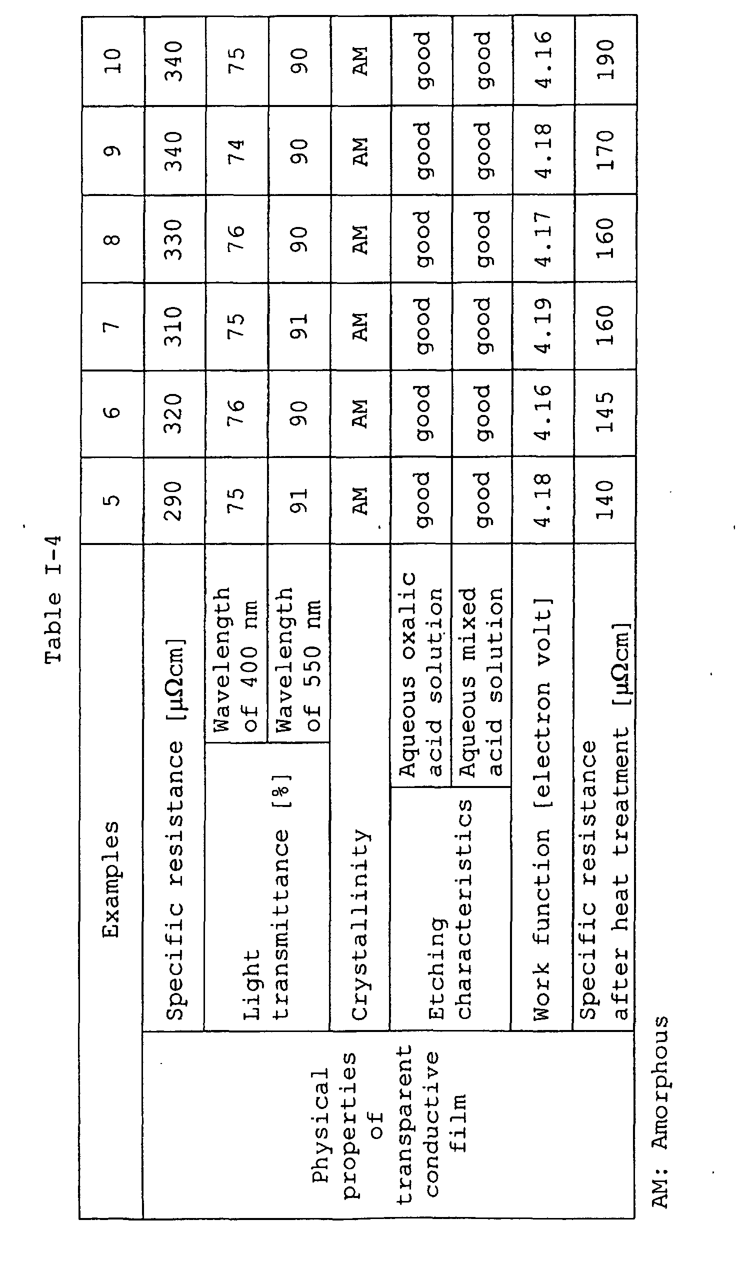

**Table I-5**

| (Comparative Examples) | | (5) | (6) |
|---|---|---|---|
| Composition | Indium oxide | 90 | 88 |
| | Tin oxide | 10 | 9 |
| | Gallium oxide | 0 | 0 |
| | Zinc oxide | 0 | 3 |
| Physical properties | Maximum crystal grain size [µm] | 7.8 | 3.5 |
| | Density [g/cm³] | 6.98 | 6.68 |
| | Bulk resistivity [×10⁻³Ωcm] | 0.48 | 0.61 |
| | Nodule formation counts | 43 | 18 |

**Table I-6**

| (Comparative Examples) | | | (5) | (6) |
|---|---|---|---|---|
| Physical properties of transparent conductive film | Specific resistance [µΩcm] | | 560 | 380 |
| | Light transmittance [%] | Wavelength of 400 nm | 75 | 67 |
| | | Wavelength of 550 nm | 88 | 90 |
| | Crystallinity | | MC | AM |
| | Etching Characteristics | Aqueous oxalic acid solution | ER | good |
| | | Aqueous mixed acid solution | ER | good |
| | Specific resistance after heat treatment [µΩcm] | | 130 | 190 |
| AM: Amorphous, MC: Microcrystalline, ER: Etching residue observed | | | | |

### [II] Second invention

The sputtering target according to the second invention (in this section, hereinafter "the second invention" may be referred to simply as "the present invention") is formed of a sintered body of metal oxide comprising indium oxide (a1) [A1] in an amount of 85 to 99 mass% and a combination of gallium oxide [B] and germanium oxide [C] in a total amount of 1 to 15 mass%, wherein at least the indium oxide present in the sintered body includes gallium atoms and germanium atoms, the two atomic species being dissolved therein by way of atomic replacement.

The indium oxide present in the sintered body including gallium atoms and germanium atoms, the two atomic species being dissolved therein by way of atomic replacement, are formed by way of atomic replacement of indium atoms contained in a portion of indium oxide crystals by gallium atoms and germanium atoms during sintering a finely divided raw material powder containing indium oxide, gallium oxide, and germanium oxide. In this case, when the entirety of gallium oxide and germanium oxide form a solid solution with indium oxide crystals by way of atomic replacement, growth of such indium oxide crystals proceeds. Furthermore, when the indium oxide crystals grow to have a grain size in excess of about 10 µm, the number of formed nodules increases.

According to the sputtering target of the present invention, indium oxide crystals form a solid solution with a portion of gallium oxide and germanium oxide-serving as sources of the sintered body-by way of atomic replacement, whereby crystal growth of indium oxide can be suppressed. The remainder portions of gallium oxide and germanium oxide are present in crystal grain boundaries of indium oxide and further suppress crystal growth of indium oxide. According to the constitution of the present invention, nodule formation during sputtering can be prevented.

The component (a1) of the sputtering target predominantly contains indium oxide, a portion of which includes gallium atoms and germanium atoms, the two atomic species being dissolved therein by way of atomic replacement. Such indium oxide including gallium and such indium oxide including germanium, the two atomic species being dissolved therein by way of atomic replacement, can be identified through analysis; for example, EPMA (Electron Probe Micro-Analysis).

The maximum grain size of the indium oxide crystals including gallium atoms and germanium atoms, the two atomic species being dissolved therein by way of atomic replacement, is determined through the following procedure. After the surface of the sputtering target has been polished, the surface is observed at five points under a scanning electron microscope at a magnification of ×2,500. In the case where the sputtering target has a circular cross-section, the five points include the center of the circle (one point) and midpoints (four points) between the periphery and the center, the midpoints located on two lines which intersect each other at right angle at the center. In the case where the sputtering target has a square cross-section, the five points include the center of the square (one point) and respective midpoints (four points) between the vertices and the center, the midpoints located on the two diagonals which intersect each other at the center. The longest diameter of the largest grain observed at each point (frame of 50 µm × 50 µm) is measured, and the longest diameter values measured in the five frames are averaged.

The indium oxide crystals which include gallium atoms or germanium atoms and are present in the sputtering target, the two atomic species being dissolved therein by way of atomic replacement, preferably have a maximum grain size controlled to 5 µm or less. This is because when the maximum grain size of indium oxide crystals including gallium atoms or germanium atoms, the two atomic species being dissolved therein by way of atomic replacement, is in excess of 5 µm, growth of indium oxide crystals including no metallic atoms to be dissolved therein by way of atomic replacement proceeds. In other words, by controlling the maximum grain size of indium oxide crystals including gallium atoms or germanium atoms, the two atomic species being dissolved therein by way of atomic replacement, to be 5 µm or less, growth of indium oxide crystals can be prevented. More preferably, the maximum grain size of indium oxide crystals including gallium atoms or germanium atoms, the two atomic species being dissolved therein by way of atomic replacement, is 3 µm or less.

The composition of the sintered body used for producing the sputtering target is controlled such that the sintered body contains the [A1] component in an amount of 85 to 99 mass% and a combination the [B] component and the [C] component in a total amount of 1 to 15 mass%. The reasons why the total amount of the [B] component and the [C] component is controlled to 1 to 15 mass% are as follows. When the total amount of the two components is less than 1 mass%, the amounts of gallium atoms and germanium atoms dissolved in indium oxide crystals by way of atomic replacement decrease, failing to attain sufficient effect of preventing growth of indium oxide crystals, whereas when the total amount of the two components is in excess of 15 mass%, the grain size of indium oxide crystals including gallium atoms and germanium atoms, the two species being dissolved therein by way of atomic replacement, is difficult to control, and conductivity of the obtained transparent conductive film decreases. Regarding the compositional proportions of the components constituting the sintered body, the sintered body is preferably composed of the component [A1] in an amount of 90 to 97 mass% and a combination of the component [B] and the component [C] in a total amount of 3 to 10 mass%.

Preferably, the component [B] (gallium oxide component) content is equal to or greater than the component [C] (germanium oxide component) content, since the transparent conductive film obtained by sputtering the sputtering target has excellent light transmittance. The component [B] content is more preferably at least 1.5 times the component [C] content, further more preferably at least twice the component [C] content.

The sputtering target according to the present invention may also be formed of a sintered body of 4-component metal oxide comprising a combination of indium oxide (a2) and tin oxide (a3) [A2] in a total amount of 90 to 99 mass% and a combination of gallium oxide [B] and germanium oxide [C] in a total amount of 1 to 10 mass%, wherein at least the indium oxide present in the sintered body includes tin atoms, gallium atoms, and germanium atoms, the three atomic species being dissolved therein by way of atomic replacement.

The indium oxide present in the sintered body including tin atoms, gallium atoms, and germanium atoms present in the sintered body, the three atomic species being dissolved therein by way of atomic replacement, are formed by way of atomic replacement of indium atoms contained in a portion of indium oxide crystals by tin atoms, gallium atoms, and germanium atoms during sintering a finely divided raw material powder containing indium oxide, tin oxide, gallium oxide, and germanium oxide.

When the entirety of tin oxide, gallium oxide, and germanium oxide form a solid solution with indium oxide crystals through atomic replacement, growth of such indium oxide crystals proceeds, thereby increasing the number of formed nodules. Thus, according to the present invention, indium oxide crystals form a solid solution with a portion of tin oxide, gallium oxide, and germanium oxide by way of atomic replacement, whereby crystal growth of indium oxide can be suppressed. The other portions of tin oxide, gallium oxide, and germanium oxide are present in crystal grain boundaries of indium oxide and further suppress crystal growth of indium oxide, thereby preventing nodule formation during sputtering.

The indium oxide crystals which include, tin atoms, gallium atoms, or germanium atoms and are present in the sputtering target formed of the 4-component metal oxide, the three atomic species being dissolved therein by way of atomic replacement, preferably have a maximum grain size controlled to 5 µm or less. This is because when the grain size of indium oxide crystals including tin atoms, gallium atoms, or germanium atoms, the three atomic species being dissolved therein by way of atomic replacement, is in excess of 5 µm, growth of indium oxide crystals including no metallic atoms to be dissolved therein by way of atomic replacement proceeds. In other words, by controlling the maximum grain size of indium oxide crystals including tin atoms, gallium atoms, or germanium atoms, the three atomic species being dissolved therein by way of atomic replacement, to be 5 µm or less, growth of indium oxide crystals can be prevented. More preferably, the maximum grain size of indium oxide crystals including tin atoms, gallium atoms, or germanium atoms, the three atomic species being dissolved therein by way of atomic replacement, is 3 µm or less.

The composition of the sintered body used for producing the sputtering target of metal oxide is controlled such that the sintered body contains the [A2] component in an amount of 90 to 99 mass% and a combination the [B] component and the [C] component in a total amount of 1 to 10 mass%. The reasons why the total amount of the [B] component and the [C] component is controlled to 1 to 10 mass% are as follows. When the total amount of the two components is less than 1 mass%, the amounts of tin atoms, gallium atoms, and germanium atoms dissolved in indium oxide crystals by way of atomic replacement decrease, failing to attain sufficient effect of , preventing growth of indium oxide crystals, and etching characteristics of the transparent conductive film formed by sputtering the sputtering target are deteriorated, whereas when the total amount of the two components is in excess of 10 mass%, the grain size of indium oxide crystals including tin atoms, gallium atoms, and germanium atoms, the three species being dissolved therein by way of atomic replacement, is difficult to control, and conductivity of the obtained transparent conductive film decreases.

Regarding the compositional proportions of the components constituting the sintered body, the sintered body is more preferably composed of the component [A2] in an amount of 90 to 98 mass% and a combination of the component [B] and the component [C] in a total amount of 2 to 10 mass%. Still more preferably, the sintered body is composed of the component [A2] in an amount of 92 to 97 mass% and a combination of the component [B] and the component [C] in a total amount of 3 to 8 mass%.

The amount of tin oxide component serving as the (a3) component contained in the [A2] component-is preferably 3 to 20 mass%. The reasons why the amount of the tin oxide component preferably falls within the above range are as follows. When the amount of tin oxide component is less than 3 mass%, sufficient doping effect on the transparent conductive film produced by sputtering the sputtering target fails to be attained during heat treatment, and conductivity of the film may fail to increase, whereas when the amount of the tin oxide component is in excess of 20 mass%, crystallinity of the transparent conductive film cannot be enhanced upon heat treatment, thereby requring higher heat treatment temperature. The amount of the component (a3) is more preferably 5 to 15 mass%, further more preferably 5 to 12 mass%.

Regarding the amounts of the component [B] and the component [C] constituting the sputtering target, the component [B] (gallium oxide component) content is preferably equal to or greater than the component [C] (germanium oxide component) content, since the transparent conductive film obtained by sputtering the sputtering target has excellent light transmittance. The component [B] content is more preferably at least 1.5 times the component [C] content, further more preferably at least twice the component [C] content.

Next, the sputtering target can be produced through, for example, the following procedure. Powders of indium oxide, gallium oxide, germanium oxide, and optional tin oxide are mixed and pulverized, to thereby produce fine powder. The fine powder is granulated through casting or spray drying, and the formed granules are press-molded and sintered. The sintered body is cut, to thereby produce the sputtering target. Mixing and pulverization of metal oxides serving as raw materials can be performed by means of a wet-type mixing-pulverizer; e.g., a wet ball mill or a beads mill, or through ultrasonication. Raw material powders are preferably pulverized so that the pulverized product has a mean particle size of 1 µm or less.

The above metal oxide is fired in air or an oxygen-containing atmosphere at 1,300 to 1,700°C, preferably 1,450 to 1,600°C for 2 to 36 hours, preferably 4 to 24 hours. The temperature elevation rate during firing preferably falls within a range of 2 to 10 °C/min. The thus-obtained sintered body is cut, to thereby form sputtering target having a suitable shape adaptable to a sputtering apparatus. The target is attached to a jig for placing the target in the sputtering apparatus.

The transparent conductive film of the present invention is formed on a substrate by sputtering the aforementioned sputtering target. The same substrates as mentioned in relation to the first invention can be employed as the substrate.

A variety of sputtering apparatuses can be employed for forming the film through sputtering. Particularly, a magnetron sputtering apparatus is preferably used. When such a magnetron sputtering apparatus is used, the same conditions as mentioned in relation to the first invention can be employed.

The thus-produced transparent conductive film of the present invention is formed of a metal oxide comprising indium oxide (a1) [A1] in an amount of 85 to 99 mass% and a combination of gallium oxide [B] and germanium oxide [C] in a total amount of 1 to 15 mass%, wherein at least the indium oxide present in a sintered body serving as the source of the film includes gallium atoms and germanium atoms, the two atomic species being dissolved therein by way of atomic replacement.

Since the transparent conductive film is composed of the component [A1] in an amount of 85 to 99 mass% and a combination of the component [B] and the component [C] in a total amount of 1 to 15 mass%, the film exhibits excellent transparency and conductivity and has excellent etching characteristics by virtue of its amorphous nature. When the total amount of the component [B] and the component [C] is less than 1 mass%, the transparent conductive film has a crystalline nature, thereby reducing etching processability, whereas when the total amount of the component [B] and the component [C] is in excess of 15 mass%, conductivity of the transparent conductive film decreases. In addition, the transparent conductive film preferably has a composition in which the amount of the component [A1] and the total amount of the component [B] and the component [C] are 90 to 97 mass% and 3 to 10 mass%, respectively, from the viewpoint of more excellent conductivity and etching characteristics.

The transparent conductive film of the present invention is formed of a 4-component metal oxide comprising a combination of indium oxide (a2) and tin oxide (a3) [A2] in a total amount of 90 to 99 mass% and a combination of gallium oxide [B] and germanium oxide [C] in a total amount of 1 to 10 mass%, wherein at least the indium oxide present in a sintered body serving as the source of the film includes tin atoms, gallium atoms, and germanium atoms, the three atomic species being dissolved therein by way of atomic replacement.

Since the transparent conductive film is formed of the 4-component metal oxide composed of the component [A2] (i.e., the (a2) component and the (a3) component) in a total amount of 90 to 99 mass% and a combination of the component [B] and the component [C] in a total amount of 1 to 10 mass%, the film exhibits excellent transparency and conductivity and has excellent etching characteristics by virtue of its amorphous nature. When the total amount of the component [B] and the component [C] is less than 1 mass%, the transparent conductive film has a crystalline nature, thereby reducing etching processability, whereas when the total amount of the component [B] and the component [C] is in excess of 10 mass%, conductivity of the transparent conductive film decreases. In addition, the transparent conductive film preferably has a composition in which the amount of the component [A2] and the total amount of the component [B] and the component [C] are 90 to 98 mass% and 2 to 10 mass%, respectively. More preferably, the transparent conductive film is has a composition in which the amount of the component [A2] and the total amount of the component [B] and the component [C] are 92 to 97 mass% and 3 to 8 mass%, respectively.

When the transparent conductive film formed of the 4-component metal oxide is subjected to heat treatment at 230°C or higher after film formation, a crystalline transparent conductive film having excellent conductivity can be produced. The heat treatment is preferably performed at 250°C or higher, more preferably 260°C or higher. In this case, the heat treatment is performed for 0.1 to five hours. The heat treatment is performed preferably after completion of patterning of the amorphous transparent conductive film obtained by sputtering the sputtering target. The patterning can be performed through a conventional method such as photolithography.

The thus-produced transparent conductive film is endowed with excellent light transmittance; i.e., 75 to 80% for a beam of 400 nm and 90% or higher for a beam of 550 nm. The film also has high conductivity and a work function lower than 4.6 eV. Thus, when the film is used in an organic electroluminescence element, contact resistance with an electron injection layer can be suppressed to a low level. Accordingly, the transparent conductive film is suitably employed as a transparent electrode used in a variety of display devices such as liquid crystal display devices and organic electroluminescence display elements, which are required to have high transparency and conductivity.

The present invention will next be described in more detail by way of Examples and Comparative Examples.

### [Example II-1]

### (1) Production of sputtering target

Indium oxide powder, gallium oxide powder, and germanium oxide powder, serving as raw materials, were mixed such that the compositional proportions of the components were adjusted to 86 parts by mass, 10 parts by mass, and 4 parts by mass, respectively. The thus-prepared metal oxide powder mixture was fed to a wet ball mill and pulverized through mixing for 10 hours, to thereby form a raw material powder having a mean particle size of 1.8 to 2 µm. The thus-formed raw material powder was dried and granulated by means of a spray drier. The resultant granules were charged into a metal mold and press-molded by means of a presser, to thereby obtain a molded disk (diameter: 10 cm, thickness: 5 mm).

The obtained molded disk was placed in a sintering furnace and sintered in a pressurized oxygen gas atmosphere for six hours, while the sintering temperature was maintained within a range of 1,420 to 1,480°C.

Through composition analysis, the thus-formed sintered body was found to be composed of the component [A1] in an amount of 86 mass%, the component [B] in an amount of 10 mass%, and the component [C] in an amount of 4 mass%. EPMA of the above sintered body revealed that the product contained indium oxide crystals including gallium atoms and indium oxide crystals including germanium atoms, the two atomic species being dissolved therein by way of atomic replacement. In addition, gallium oxide including indium atoms and germanium oxide including indium atoms, the indium atoms being dissolved therein by way of atomic replacement, were also identified. The maximum crystal grain size of the sintered body was determined to be 2.3 µm through the following procedure. Briefly, the sintered disk product was photographed at five points under a scanning electron microscope at a magnification of ×2,500, wherein the five points included the center of the circle (one point) and midpoints (four points) between the periphery and the center, the midpoints located on two lines which intersect each other at right angle at the center. The longest diameter of the largest grain observed at each point (frame of 50 µm × 50 µm) was measured, and the longest diameter values measured in the five frames were averaged. The sintered body was found to have a density of 6.65 g/cm³, which is 96% the corresponding theoretical density. The bulk resistivity of the sintered body, as determined through the four-probe method, was found to be 3.8 × 10⁻³ Ω·cm.

The thus-produced sintered body was cut, to thereby produce a sputtering target having a diameter of about 10 cm and a thickness of about 5 mm.

### (2) Observation of nodule formation

The surface conditions of the target were observed through the same procedure as mentioned in relation to the first invention. Through this procedure, no nodule was identified on the surface of the sputtering target used herein.

The composition, physical properties, and observation regarding nodule formation of the sputtering target produced in the Example are shown in Table II-1.

In the Table, "Example II-1" is abbreviated as "Example 1" for the sake of convenience. The same convention is applied to Comparative Examples and to Tables II-1 to II-6.

### (3) Production of transparent conductive film

The transparent conductive film was produced through the same procedure as mentioned in relation to the first invention. As a result, a transparent conductive film having a thickness of about 2,000 Å was formed on the glass substrate, whereby a transparent glass plate was produced.

### (4) Evaluation of transparent conductive film

The transparent conductive film serving as a surface layer of the transparent conductive glass plate obtained in (3) above was evaluated in terms of the following properties. The results are shown in Table II-2.

### (1) Conductivity

As an index for conductivity, specific resistance of the transparent conductive film was measured through the four-probe method and found to be 480 × 10⁻⁶ Ω·cm.

### (2) Transparency

As an index for transparency, light transmittance of the film was measured by means of a spectrophotometer and found to be 78% for a beam of 400 nm and 91% for a beam of 550 nm.

### (3) Crystallinity

Crystallinity of the film was determined through X-ray diffractometry, revealing that the transparent conductive film was amorphous.

### (4) Etching characteristics

Etching characteristics were investigated through the same procedure as mentioned in relation to the first invention. No etching residue was observed on the etched surface of the transparent conductive film.

### (5) Work function

Work function of the transparent conductive film was measured through atmospheric ultraviolet photoelectron spectroscopy and was found to be 4.4 eV.

### [Example II-2]

### (1) Production of sputtering target and observation of nodule formation

The procedure of Example II-1 (1) was repeated, except that indium oxide, gallium oxide, and germanium oxide were used as raw materials in amounts of 91 parts by mass, 6 parts by mass, and 3 parts by mass, respectively, to thereby produce a sputtering target.

In a manner similar to that employed in Example II-1 (2), the sputtering target was observed so as to identify nodule formation during sputtering.

The composition, physical properties, and observation regarding nodule formation of the sputtering target are shown in Table II-1.

### (2) Production and evaluation of transparent conductive film

The procedure of Example II-1 (3) was repeated, except that the sputtering target which had been produced in (1) above was sputtered, to thereby produce a transparent conductive film.

In a manner similar to that employed in Example II-1 (4), the transparent conductive film was evaluated. The results are shown in Table II-2.

### [Example II-3]

### (1) Production of sputtering target and observation of nodule formation

The procedure of Example II-1 (1) was repeated, except that indium oxide, gallium oxide, and germanium oxide were used as raw materials in amounts of 93 parts by mass, 4 parts by mass, and 3 parts by mass, respectively, to thereby produce a sputtering target.

In a manner similar to that employed in Example II-1 (2), the sputtering target was observed so as to identify nodule formation during sputtering.

The composition, physical properties, and observation regarding nodule formation of the sputtering target are shown in Table II-1.

### (2) Production and evaluation of transparent conductive film

The procedure of Example II-1 (3) was repeated, except that the sputtering target which had been produced in (1) above was sputtered, to thereby produce a transparent conductive film.

In a manner similar to that employed in Example II-1 (4), the transparent conductive film was evaluated. The results are shown in Table II-2.

### [Example II-4]

### (1) Production of sputtering target and observation of nodule formation

The procedure of Example II-1 (1) was repeated, except that indium oxide, gallium oxide, and germanium oxide were used as raw materials in amounts of 95 parts by mass, 3 parts by mass, and 2 parts by mass, respectively, to thereby produce a sputtering target.

In a manner similar to that employed in Example II-1 (2), the sputtering target was observed so as to identify nodule formation during sputtering.

The composition, physical properties, and observation regarding nodule formation of the sputtering target are shown in Table II-1.

### (2) Production and evaluation of transparent conductive film

The procedure of Example II-1 (3) was repeated, except that the sputtering target which had been produced in (1) above was sputtered, to thereby produce a transparent conductive film.

In a manner similar to that employed in Example II-1 (4), the transparent conductive film was evaluated. The results are shown in Table II-2.

### [Comparative Example II-1]

### (1) Production of sputtering target and observation of nodule formation

The procedure of Example II-1 (1) was repeated, except that only indium oxide powder was used as a raw material, to thereby produce a sputtering target.

In a manner similar to that employed in Example II-1 (2), the sputtering target was observed so as to identify nodule formation during sputtering. Through observation at a magnification of ×50, 45 nodules were identified in a field of vision (3 mm²) on the surface of the sputtering target after completion of sputtering for continuous 30 hours.

The composition, physical properties, and observation regarding nodule formation of the sputtering target are shown in Table II-1.

### (2) Production and evaluation of transparent conductive film

The procedure of Example II-1 (3) was repeated, except that the sputtering target which had been produced in (1) above was sputtered, to thereby produce a transparent conductive film.

In a manner similar to that employed in Example II-1 (4), the transparent conductive film was evaluated. The results are shown in Table II-2.

### [Comparative Example II-2]

### (1) Production of sputtering target and observation of nodule formation

The procedure of Example II-1 (1) was repeated, except that indium oxide and gallium oxide were used as raw materials in amounts of 94 parts by mass and 6 parts by mass, respectively, to thereby produce a sputtering target.

In a manner similar to that employed in Example II-1 (2), the sputtering target was observed so as to identify nodule formation during sputtering. Through observation at a magnification of ×50, 24 nodules were identified in a field of vision (3 mm²) on the surface of the sputtering target after completion of sputtering for continuous 30 hours.

The composition, physical properties, and observation regarding nodule formation of the sputtering target are shown in Table II-1.

### (2) Production and evaluation of transparent conductive film

The procedure of Example II-1(3) was repeated, except that the sputtering target which had been produced in (1) above was sputtered, to thereby produce a transparent conductive film.

In a manner similar to that employed in Example II-1 (4), the transparent conductive film was evaluated. The results are shown in Table II-2.

### [Comparative Example II-3]

### (1) Production of sputtering target and observation of nodule formation

The procedure of Example II-1 (1) was repeated, except that indium oxide and germanium oxide were used as raw materials in amounts of 94 parts by mass and 6 parts by mass, respectively, to thereby produce a sputtering target.

In a manner similar to that employed in Example II-1 (2), the sputtering target was observed so as to identify nodule formation during sputtering. Through observation at a magnification of ×50, 21 nodules were identified in a field of vision (3 mm²) on the surface of the sputtering target after completion of sputtering for continuous 30 hours.

The composition, physical properties, and observation regarding nodule formation of the sputtering target are shown in Table II-1.

### (2) Production and evaluation of transparent conductive film

The procedure of Example II-1 (3) was repeated, except that the sputtering target which had been produced in (1) above was sputtered, to thereby produce a transparent conductive film.

In a manner similar to that employed in Example II-1 (4), the transparent conductive film was evaluated. The results are shown in Table II-2.

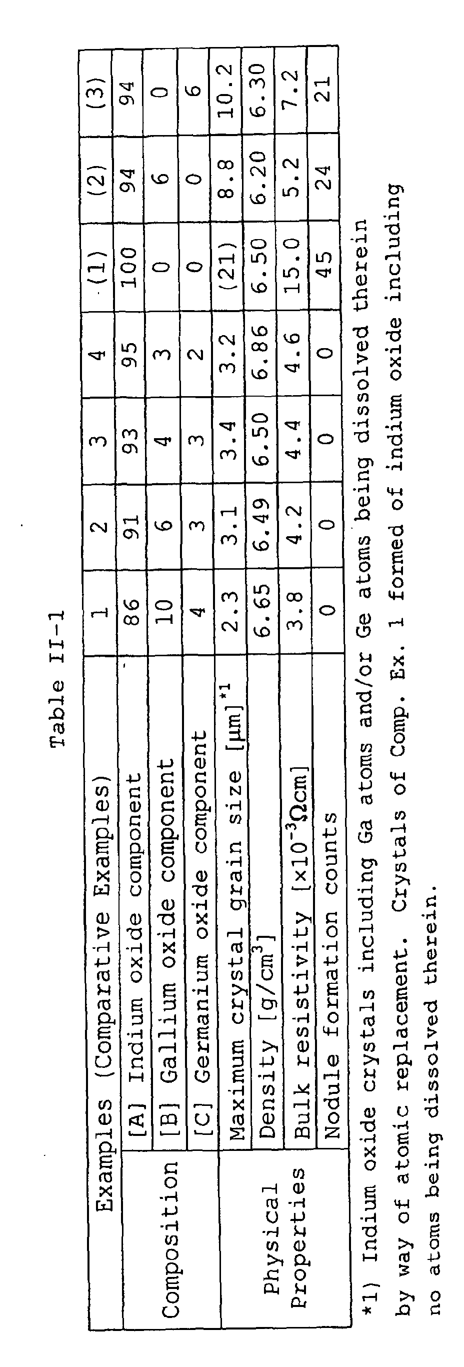

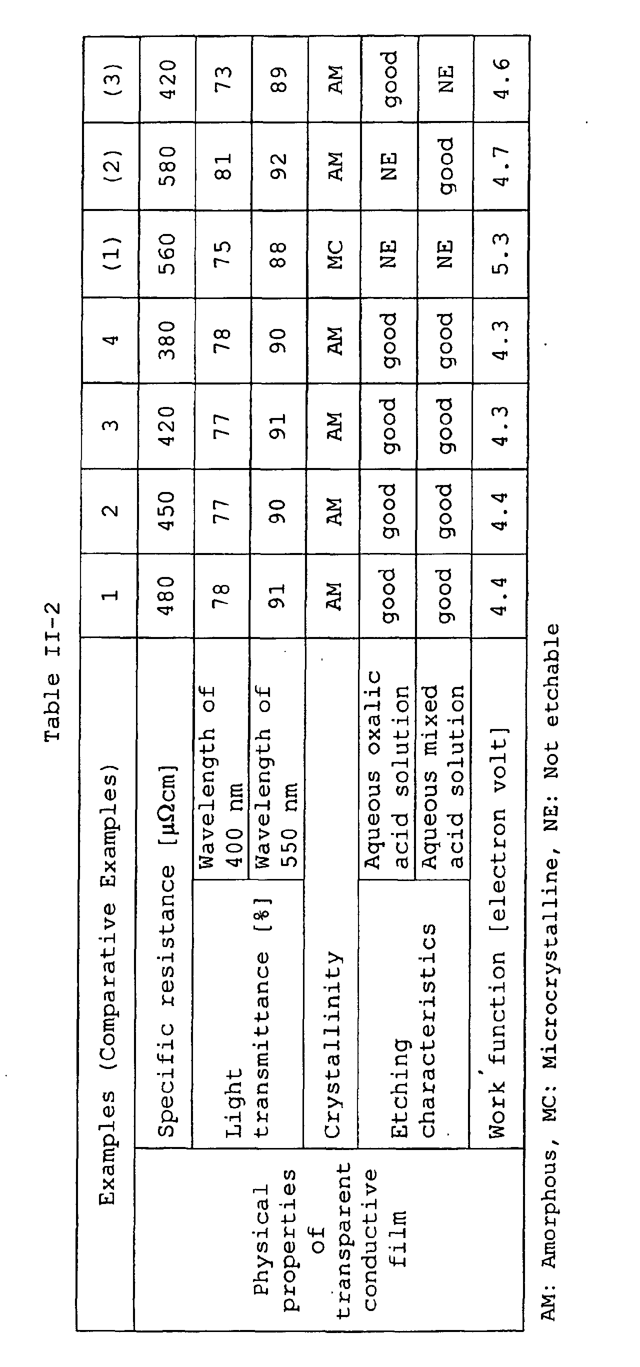

### [Example II-5]

### (1) Production of sputtering target and observation of nodule formation

The procedure of Example II-1 (1) was repeated, except that indium oxide, tin oxide, gallium oxide, and germanium oxide were used as raw materials in amounts of 86 parts by mass, 6 parts by mass, 6 parts by mass, and 2 parts by mass, respectively, to thereby form a sintered body. EPMA of the above sintered body revealed that the product contained indium oxide crystals including tin atoms, indium oxide crystals including gallium atoms, and indium oxide crystals including germanium atoms, the three atomic species being dissolved therein by way of atomic replacement. In addition, tin oxide including indium atoms, gallium oxide including indium atoms, and germanium oxide including indium atoms, the indium atoms being dissolved therein by way of atomic replacement were also identified. The thus-produced sintered body was processed in a manner similar to that of Example II-1 (1), to thereby produce a sputtering target.

In a manner similar to that employed in Example II-1 (2), the produced sputtering target was observed so as to identify nodule formation during sputtering.

The composition, physical properties, and observation regarding nodule formation of the sputtering target are shown in Table II-3.

### (2) Production and evaluation of transparent conductive film

The procedure of Example II-1 (3) was repeated, except that the sputtering target which had been produced in (1) above was sputtered, to thereby produce a transparent conductive film.

In a manner similar to that employed in Example II-1 (4), the transparent conductive film was evaluated. The results are shown in Table II-4.

### [Example II-6]

### (1) Production of sputtering target and observation of nodule formation

The procedure of Example II-1 (1) was repeated, except that indium oxide, tin oxide, gallium oxide, and germanium oxide were used as raw materials in amounts of 88 parts by mass, 6 parts by mass, 4 parts by mass, and 2 parts by mass, respectively, to thereby produce a sputtering target.

In a manner similar to that employed in Example II-1 (2), the sputtering target was observed so as to identify nodule formation during sputtering.

The composition, physical properties, and observation regarding nodule formation of the sputtering target are shown in Table II-3

### (2) Production and evaluation of transparent conductive film

The procedure of Example II-1 (3) was repeated, except that the sputtering target which had been produced in (1) above was sputtered, to thereby produce a transparent conductive film.

In a manner similar to that employed in Example II-1 (4), the transparent conductive film was evaluated. The results are shown in Table II-4

### [Example II-7]

### (1) Production of sputtering target and observation of nodule formation

The procedure of Example II-1 (1) was repeated, except that indium oxide, tin oxide, gallium oxide, and germanium oxide were used as raw materials in amounts of 83 parts by mass, 8 parts by mass, 6 parts by mass, and 3 parts by mass, respectively, to thereby produce a sputtering target.

In a manner similar to that employed in Example II-1 (2), the sputtering target was observed so as to identify nodule formation during sputtering.

The composition, physical properties, and observation regarding nodule formation of the sputtering target are shown in Table II-3

### (2) Production and evaluation of transparent conductive film

The procedure of Example II-1 (3) was repeated, except that the sputtering target which had been produced in (1) above was sputtered, to thereby produce a transparent conductive film.

In a manner similar to that employed in Example II-1 (4), the transparent conductive film was evaluated. The results are shown in Table II-4

### [Example II-8]

### (1) Production of sputtering target and observation of nodule formation

The procedure of Example II-1 (1) was repeated, except that indium oxide, tin oxide, gallium oxide, and germanium oxide were used as raw materials in amounts of 85 parts by mass, 8 parts by mass, 4 parts by mass, and 3 parts by mass, respectively, to thereby produce a sputtering target.

In a manner similar to that employed in Example II-1 (2), the sputtering target was observed so as to identify nodule formation during sputtering.

The composition, physical properties, and observation regarding nodule formation of the sputtering target are shown in Table II-3

### (2) Production and evaluation of transparent conductive film

The procedure of Example II-1 (3) was repeated, except that the sputtering target which had been produced in (1) above was sputtered, to thereby produce a transparent conductive film.

In a manner similar to that employed in Example II-1 (4), the transparent conductive film was evaluated. The results are shown in Table II-4

### [Example II-9]

### (1) Production of sputtering target and observation of nodule formation

The procedure of Example II-1 (1) was repeated, except that indium oxide, tin oxide, gallium oxide, and germanium oxide were used as raw materials in amounts of 82 parts by mass, 8 parts by mass, 6 parts by mass, and 4 parts by mass, respectively, to thereby produce a sputtering target.

In a manner similar to that employed in Example II-1 (2), the sputtering target was observed so as to identify nodule formation during sputtering.

The composition, physical properties, and observation regarding nodule formation of the sputtering target are shown in Table II-3

### (2) Production and evaluation of transparent conductive film

The procedure of Example II-1 (3) was repeated, except that the sputtering target which had been produced in (1) above was sputtered, to thereby produce a transparent conductive film.

In a manner similar to that employed in Example II-1 (4), the transparent conductive film was evaluated. The results are shown in Table II-4

### [Example II-10]

### (1) Production of sputtering target and observation of nodule formation

The procedure of Example II-1 (1) was repeated, except that indium oxide, tin oxide, gallium oxide, and germanium oxide were used as raw materials in amounts of 84 parts by mass, 8 parts by mass, 4 parts by mass, and 4 parts by mass, respectively, to thereby produce a sputtering target.

In a manner similar to that employed in Example II-1 (2), the sputtering target was observed so as to identify nodule formation during sputtering.

The composition, physical properties, and observation regarding nodule formation of the sputtering target are shown in Table II-3

### (2) Production and evaluation of transparent conductive film

The procedure of Example II-1 (3) was repeated, except that the sputtering target which had been produced in (1) above was sputtered, to thereby produce a transparent conductive film.

In a manner similar to that employed in Example II-1 (4), the transparent conductive film was evaluated. The results are shown in Table II-4

### [Comparative Example II-4]

### (1) Production of sputtering target and observation of nodule formation

The procedure of Example II-1 (1) was repeated, except that indium oxide and tin oxide were used as raw materials in amounts of 90 parts by mass and 10 parts by mass, respectively, to thereby produce a sputtering target.

In a manner similar to that employed in Example II-1 (2), the sputtering target was observed so as to identify nodule formation during sputtering.

The composition, physical properties, and observation regarding nodule formation of the sputtering target are shown in Table II-5.

### (2) Production and evaluation of transparent conductive film

The procedure of Example II-1 (3) was repeated, except that the sputtering target which had been produced in (1) above was sputtered, to thereby produce a transparent conductive film.

In a manner similar to that employed in Example II-1 (4), the transparent conductive film was evaluated. The results are shown in Table II-6.

### [Comparative Example II-5]

### (1) Production of sputtering target and observation of nodule formation

The procedure of Example II-1 (1) was repeated, except that indium oxide, tin oxide, and gallium oxide were used as raw materials in amounts of 90 parts by mass, 5 parts by mass, and 5 parts by mass, respectively, to thereby produce a sputtering target.

In a manner similar to that employed in Example II-1 (2), the sputtering target was observed so as to identify nodule formation during sputtering.

The composition, physical properties, and observation regarding nodule formation of the sputtering target are shown in Table II-5.

### (2) Production and evaluation of transparent conductive film

The procedure of Example II-1 (3) was repeated, except that the sputtering target which had been produced in (1) above was sputtered, to thereby produce a transparent conductive film.

In a manner similar to that employed in Example II-1 (4), the transparent conductive film was evaluated. The results are shown in Table II-6.

### [Comparative Example II-6]

### (1) Production of sputtering target and observation of nodule formation

The procedure of Example II-1 (1) was repeated, except that indium oxide, tin oxide, and germanium oxide were used as raw materials in amounts of 90 parts by mass, 5 parts by mass, and 5 parts by mass, respectively, to thereby produce a sputtering target.

In a manner similar to that employed in Example II-1 (2), the sputtering target was observed so as to identify nodule formation during sputtering.

The composition, physical properties, and observation regarding nodule formation of the sputtering target are shown in Table II-5.

### (2) Production and evaluation of transparent conductive film

The procedure of Example II-1 (3) was repeated, except that the sputtering target which had been produced in (1) above was sputtered, to thereby produce a transparent conductive film.

In a manner similar to that employed in Example II-1 (4), the transparent conductive film was evaluated. The results are shown in Table II-6.

### [Comparative Example II-7]

### (1) Production of sputtering target and observation of nodule formation

The procedure of Example II-1 (1) was repeated, except that indium oxide, tin oxide, gallium oxide, and germanium oxide were used as raw materials in amounts of 70 parts by mass, 10 parts by mass, 10 parts by mass, and 10 parts by mass, respectively, to thereby produce a sputtering target.

In a manner similar to that employed in Example II-1 (2), the sputtering target was observed so as to identify nodule formation during sputtering.

The composition, physical properties, and observation regarding nodule formation of the sputtering target are shown in Table II-5.

### (2) Production and evaluation of transparent conductive film

The procedure of Example II-1 (3) was repeated, except that the sputtering target which had been produced in (1) above was sputtered, to thereby produce a transparent conductive film.

In a manner similar to that employed in Example II-1 (4), the transparent conductive film was evaluated. The results are shown in Table II-6.

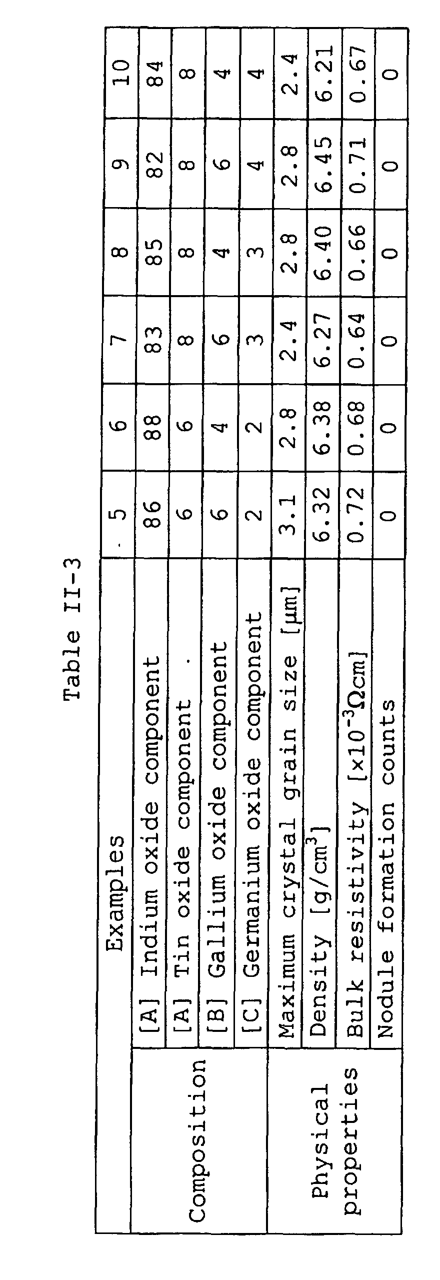

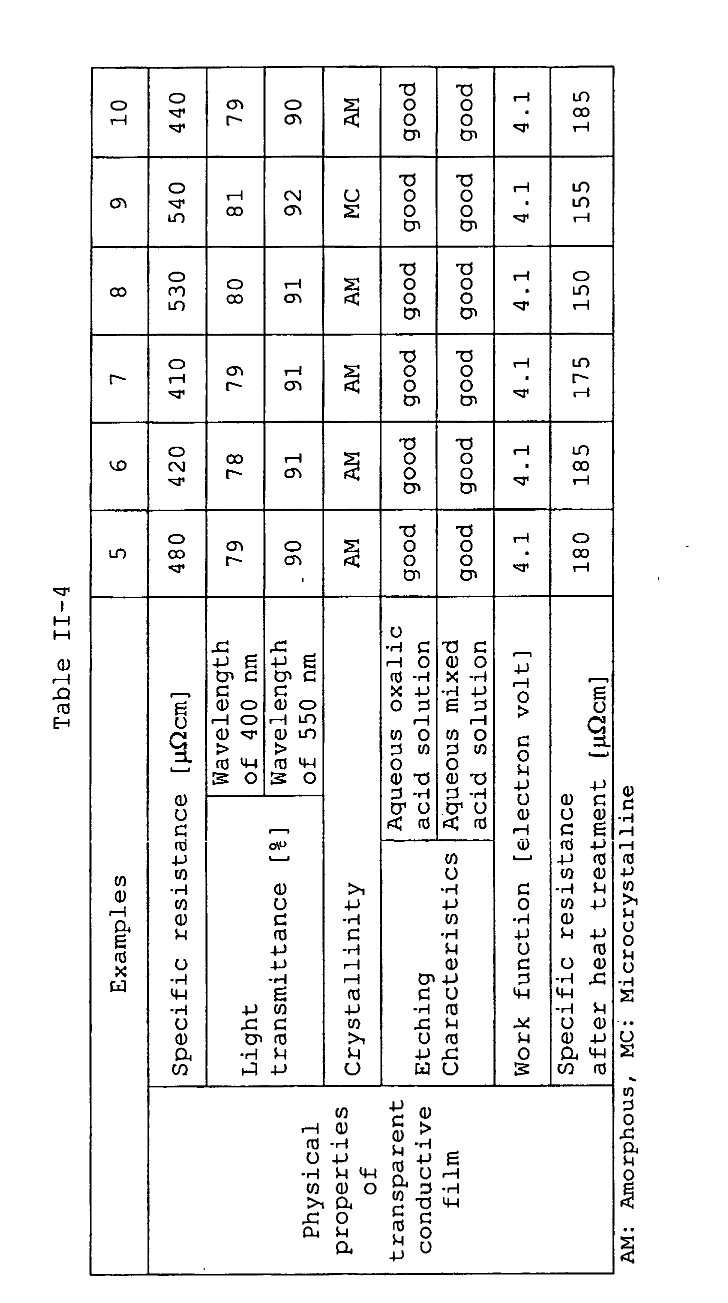

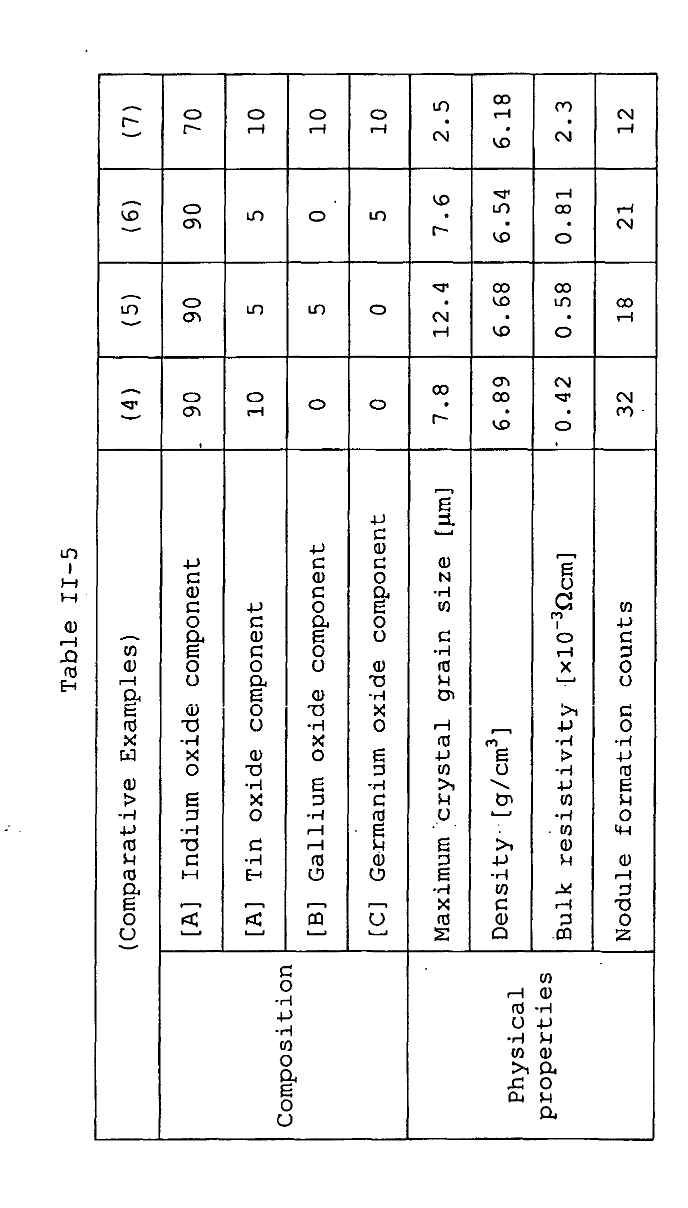

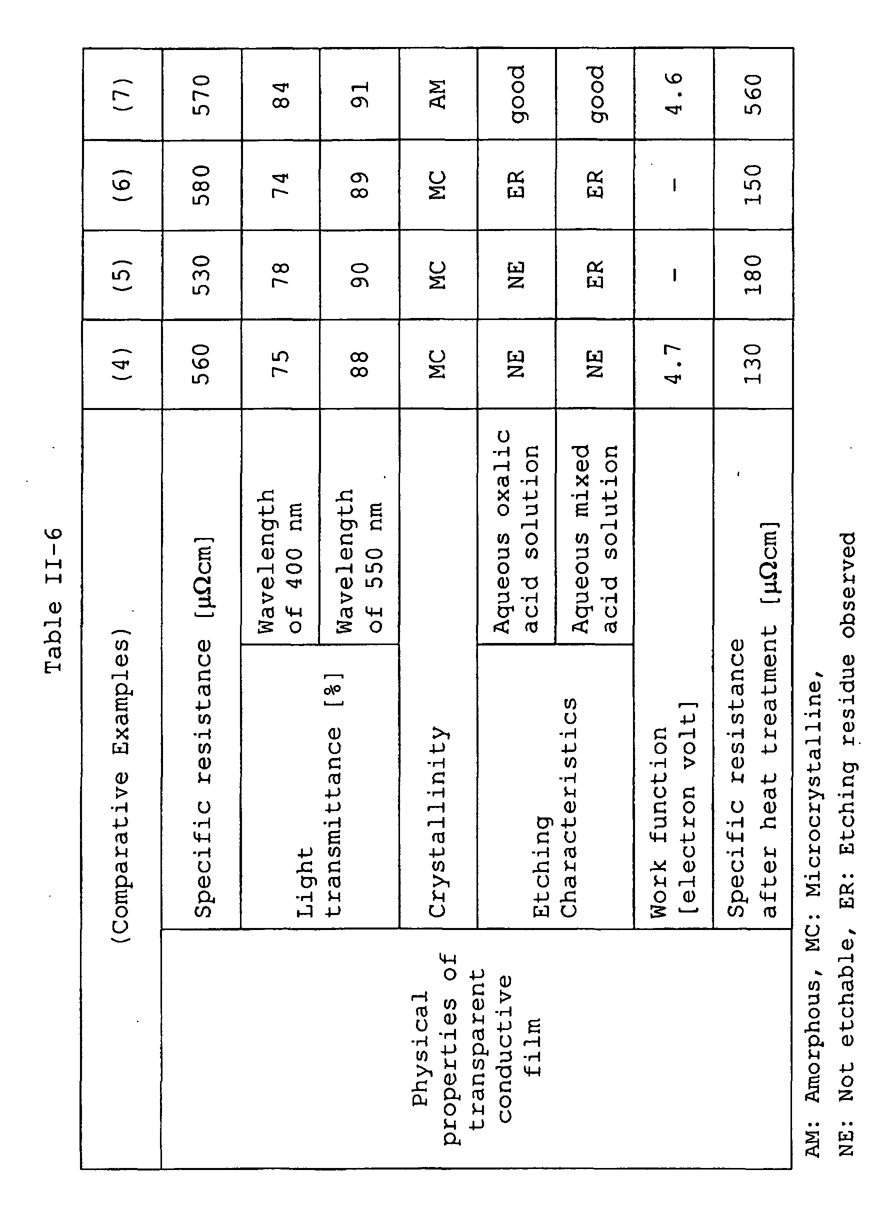

### Industrial Applicability

The sputtering target of the present invention can prevent nodule formation during sputtering for forming a transparent conductive film, realizing successful film formation with high productivity. The transparent conductive film of the present invention can be etched with a weak acid. Thus, by use of the film, electrodes can be fabricated in a device such as a thin film transistor without adversely affecting wiring material.

## Claims

1. A sputtering target formed of a sintered body of metal oxide including indium oxide, gallium oxide, and zinc oxide, wherein the metal oxide contains one or more hexagonal layered compounds selected from the group consisting of In₂O₃(ZnO)ₘ (wherein m is an integer from 2 to 10), In₂Ga₂ZnO₇, InGaZnO₄, InGaZn₂O₅, InGaZn₃O₆, InGaZn₄O₇, InGaZn₅O₈, InGaZn₆O₉, and InGaZn₇O₁₀, and the sintered body is composed of indium oxide in an amount of 90 to 99 mass% and a combination of gallium oxide and zinc oxide in a total amount of 1 to 10 mass%.

2. A sputtering target as described in claim 1, wherein the sintered body of metal oxide is composed of indium oxide in an amount of 90 to 98 mass% and a combination of gallium oxide and zinc oxide in a total amount of 2 to 10 mass%.

3. A sputtering target as described in claim 1, wherein the sintered body of metal oxide is composed of indium oxide in an amount of 92 to 97 mass% and a combination of gallium oxide and zinc oxide in a total amount of 3 to 8 mass%.

4. A sputtering target as described in any of claims 1 to 3, wherein the hexagonal layered compounds have a maximum crystal grain size of 5 µm or less.

5. A sputtering target as described in claim 4, wherein the maximum crystal grain size is 3 µm or less.

6. A sputtering target formed of a sintered body of metal oxide including indium oxide, tin oxide, gallium oxide, and zinc oxide, wherein the metal oxide contains one or more hexagonal layered compounds selected from the group consisting of In₂O₃(ZnO)ₘ (wherein m is an integer from 2 to 10), In₂Ga₂ZnO₇, InGaZnO₄, InGaZn₂O₅, InGaZn₃O₆, InGaZn₄O₇, InGaZn₅O₈, InGaZn₆O₉, and InGaZn₇O₁₀, and the sintered body is composed of indium oxide in an amount of 70 to 94 mass%, tin oxide in an amount of 5 to 20 mass%, and a combination of gallium oxide and zinc oxide in a total amount of 1 to 10 mass%.

7. A sputtering target as described in claim 6, wherein the sintered body of metal oxide is composed of indium oxide in an amount of 75 to 93 mass%, tin oxide in an amount of 5 to 15 mass%, and a combination of gallium oxide and zinc oxide in a total amount of 2 to 10 mass%.

8. A sputtering target as described in claim 6, wherein the sintered body of metal oxide is composed of indium oxide in an amount of 80 to 90 mass%, tin oxide in an amount of 7 to 12 mass%, and a combination of gallium oxide and zinc oxide in a total amount of 3 to 8 mass%.

9. A sputtering target as described in any of claim 7 or 8, wherein the hexagonal layered compounds have a maximum crystal grain size of 5 µm or less.

10. A sputtering target as described in claim 9, wherein the maximum crystal grain size is 3 µm or less.

11. A transparent conductive film formed of a metal oxide including indium oxide, gallium oxide, and zinc oxide, wherein the metal oxide is composed of indium oxide in an amount of 90 to 99 mass% and a combination of gallium oxide and zinc oxide in a total amount of 1 to 10 mass%.

12. A transparent conductive film as described in claim 11, wherein the metal oxide is composed of indium oxide in an amount of 90 to 98 mass% and a combination of gallium oxide and zinc oxide in a total amount of 2 to 10 mass%.

13. A transparent conductive film as described in claim 11, wherein the metal oxide is composed of indium oxide in an amount of 92 to 97 mass% and a combination of gallium oxide and zinc oxide in a total amount of 3 to 8 mass%.

14. A transparent conductive film formed of a metal oxide including indium oxide, tin oxide, gallium oxide, and zinc oxide, wherein the metal oxide is composed of indium oxide in an amount of 70 to 94 mass%, tin oxide in an amount of 5 to 20 mass%, and a combination of gallium oxide and zinc oxide in a total amount of 1 to 10 mass%.

15. A transparent conductive film as described in claim 14, wherein the metal oxide is composed of indium oxide in an amount of 75 to 93 mass%, tin oxide in an amount of 5 to 15 mass%, and a combination of gallium oxide and zinc oxide in a total amount of 2 to 10 mass%.

16. A transparent conductive film as described in claim 14, wherein the metal oxide is composed of indium oxide in an amount of 80 to 90 mass%, tin oxide in an amount of 7 to 12 mass%, and a combination of gallium oxide and zinc oxide in a total amount of 3 to 8 mass%.

17. A transparent conductive film which is produced by subjecting a transparent conductive film as recited in any of claims 14 to 16 to patterning and subsequent heat treatment at 230°C or higher.

18. A sputtering target formed of a sintered body of metal oxide comprising indium oxide (a1) [A1] in an amount of 85 to 99 mass% and a combination of gallium oxide [B] and germanium oxide [C] in a total amount of 1 to 15 mass%, wherein at least the indium oxide present in the sintered body includes gallium atoms and germanium atoms, the two atomic species being dissolved therein by way of atomic replacement.

19. A sputtering target as described in claim 18, wherein the sputtering target is formed of the sintered body of metal oxide composed of the component [A1] in an amount of 90 to 97 mass% and a combination of the component [B] and the component [C] in a total amount of 3 to 10 mass%.

20. A sputtering target as described in claim 18 or 19, wherein indium oxide crystals including the gallium atoms or indium oxide crystals including the germanium atoms, the two atomic species being dissolved therein by way of atomic replacement, have a maximum grain size of 5 µm or less.

21. A sputtering target as described in claim 20, wherein the maximum grain size is 3 µm or less.

22. A sputtering target formed of a sintered body of metal oxide comprising a combination of indium oxide (a2) and tin oxide (a3) [A2] in a total amount of 90 to 99 mass% and a combination of gallium oxide [B] and germanium oxide [C] in a total amount of 1 to 10 mass%, wherein at least the indium oxide present in the sintered body includes tin atoms, gallium atoms, and germanium atoms, the three atomic species being dissolved therein by way of atomic replacement.

23. A sputtering target as described in claim 22, wherein the sputtering target is formed of the sintered body of metal oxide composed of the component [A2] in an amount of 90 to 98 mass% and a combination of the component [B] and the component [C] in a total amount of 2 to 10 mass%.

24. A sputtering target as described in claim 22, wherein the sputtering target is formed of the sintered body of metal oxide composed of the component [A2] in an amount of 92 to 97 mass% and a combination of the component [B] and the component [C] in a total amount of 3 to 8 mass%.

25. A sputtering target as described in any of claims 22 to 24, wherein indium oxide crystals including tin atoms, indium oxide crystals including gallium atoms, or indium oxide crystals including germanium atoms, the three atomic species being dissolved therein by way of atomic replacement, have a maximum grain size of 5 µm or less.

26. a sputtering target as described in claim 25, wherein the maximum grain size is 3 µm or less.

27. A transparent conductive film formed of a metal oxide comprising indium oxide (a1) [A1] in an amount of 85 to 99 mass% and a combination of gallium oxide [B] and germanium oxide [C] in a total amount of 1 to 15 mass%, wherein at least the indium oxide present in a sintered body serving as the source of the film includes gallium atoms and germanium atoms, the two atomic species being dissolved therein by way of atomic replacement.

28. A transparent conductive film as described in claim 27, wherein the film is formed of a metal oxide composed of the component [A1] in an amount of 90 to 97 mass% and a combination of the component [B] and the component [C] in a total amount of 3 to 10 mass%.

29. A transparent conductive film formed of a metal oxide comprising a combination of indium oxide (a2) and tin oxide (a3) [A2] in a total amount of 90 to 99 mass% and a combination of gallium oxide [B] and germanium oxide [C] in a total amount of 1 to 10 mass%, wherein at least the indium oxide present in a sintered body serving as the source of the film includes tin atoms, gallium atoms, and germanium atoms, the three atomic species being dissolved therein by way of atomic replacement.

30. A transparent conductive film as described in claim 29, wherein the film is formed of a metal oxide composed of the component [A2] in an amount of 90 to 98 mass% and a combination of the component [B] and the component [C] in a total amount of 2 to 10 mass%.

31. A transparent conductive film as described in claim 29, wherein the film is formed of a metal oxide composed of the component [A2] in an amount of 92 to 97 mass% and a combination of the component [B] and the component [C] in a total amount of 3 to 8 mass%.

32. A transparent conductive film which is produced by subjecting a transparent conductive film as recited in any of claims 14, 15, 16, 29, 30, and 31 to heat treatment at 230°C or higher.

33. A method for producing a transparent conductive film **characterized in that** the method comprises sputtering a sputtering target as recited in any of claims 1 to 10 and 18 to 26 for forming film.
